# EUROPEAN PATENT SPECIFICATION

(11) **EP 2 966 693 B1**
(45) Date of publication and mention of the grant of the patent: **03.05.2023**
(21) Application number: 15002025.3
(22) Date of filing: 06.07.2015
(51) Int. Cl.: H01L 31/0224, H01L 31/05, H01L 31/042

(54) **SOLAR CELL MODULE**
SOLARZELLENMODUL
MODULE DE CELLULE SOLAIRE

(30) Priority: 07.07.2014 KR 20140084829; 04.08.2014 KR 20140100083; 04.08.2014 KR 20140100084; 08.10.2014 KR 20140136153
(43) Date of publication of application: 13.01.2016
(60) Divisional application: 18177739.2
(73) Proprietor: Shangrao Jinko solar Technology Development Co., LTD, JIANGXI PROVINCE (CN)
(72) Inventor: Jang, Daehee, 153-802 Seoul (KR); Kim, Minpyo, 153-802 Seoul (KR); Kim, Jinsung, 153-802 Seoul (KR); Hwang, Sunghyun, 153-802 Seoul (KR); Cho, Haejong, 153-802 Seoul (KR); Yang, Hyeyoung, 153-802 Seoul (KR); Oh, Donghae, 153-802 Seoul (KR); Lim, Chunghyun, 153-802 Seoul (KR); Shin, Taehee, 153-802 Seoul (KR); Yu, Jeonghun, 153-802 Seoul (KR)
(74) Representative: DREISS Patentanwälte PartG mbB

(56) References cited:
- EP-A2- 2 511 957
- WO-A1-2013/069425
- CN-U- 201 838 602
- DE-A1-102011 078 371
- JP-A- S60 239 067
- US-A- 4 487 989
- US-A1- 2010 024 881

## Description

### CROSS-REFERENCE TO RELATED APPLICATION

### BACKGROUND OF THE INVENTION

### Field of the Invention

Embodiments of the invention relate to a solar cell module including a plurality of solar cells connected to one another using a plurality of wiring members.

### Description of the Related Art

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted because the solar cells have an abundant energy source in sunlight and do not cause environmental pollution.

A solar cell generally includes a substrate which contains p-type impurities or n-type impurities and has the conductivity, an emitter region and a back surface field region, each of which is more heavily doped than the substrate with impurities, and electrodes which are electrically connected to the emitter region and the back surface field region, respectively. In this instance, a p-n junction is formed between the substrate and the emitter region and produces electrical energy using a photoelectric effect.

When light is incident on the solar cell, a plurality of electron-hole pairs are produced in the semiconductors. The electron-hole pairs are separated into electrons and holes. The electrons move to the n-type semiconductor, for example, the emitter region and then are collected by the electrodes connected to the emitter region, and the holes move to the p-type semiconductor, for example, the back surface field region and then are collected by the electrodes connected to the back surface field region. The electrodes are connected to each other using electric wires to thereby obtain electric power.

US 4 487 989 A discloses a solar cell having a rear electrical contact for the semiconductor body of the cell forming an intersecting pattern which includes rows of contact pads which are parallel to a pair of sides of the body; a set of contact strips which also are parallel to such sides; another set of contact strips which are parallel to another pair of sides of the body perpendicular to the first pair of sides; and yet another set of contact strips which are angularly oriented with respect to both pairs of sides of the body. The contact pattern permits the passage of radiation through the cell which would otherwise decrease efficiency due to heat generation and incorporates additional features designed to balance a desire for transparency to such radiation with a requirement for efficient charge collection along the rear of the cell. The front electrical contact for the semiconductor body forms an intersecting pattern, designed to balance the requirement for the entry of solar radiation into the body with the efficient collection of charges at the front of the solar cell, which is similar in some details to the rear electrical contact but significantly different as to other details.

JP S60 239067 A discloses a solar cell having excellent adhesive strength with leads and small shadow-loss of beams by forming a pattern with its width smaller than lead wires between divided bus bar electrodes.

CN 201 838 602 U discloses a solar battery, in particular to a crystalline silicon solar battery with segmented grid lines. In the document the crystalline silicon solar battery is described to comprise a crystalline silicon wafer, a surface electrode and a back surface electrode, wherein the surface electrode is arranged on the illumination surface of the crystalline silicon wafer, and the back surface electrode is arranged on the backlight surface of the crystalline silicon wafer, and the surface electrode comprises a linear grid line and a main grid line which are connected with each other, and the main grid line which is arranged in a segmented way is formed through serial connection of at least two sheeted grid lines.

WO 2013/069425 A1 discloses a solar cell module. In the document the solar cell module is described to comprise a wiring material which electrically connects solar cell elements, and a solder joint section which is formed on the light receiving surfaces of the solar cell elements, extends in a first direction parallel to the wiring material, has a smaller width than the wiring material in a cross-section thereof perpendicular to the first direction, and is formed by joining the wiring material and current collecting electrodes by melting solder.

### SUMMARY OF THE INVENTION

The present invention is defined by the independent claim. Specific embodiments are defined by the dependent claims.

### BRIEF DESCRIPTION OF THE DRAWINGS

The accompanying drawings, which are included to provide a further understanding of the invention and are incorporated in and constitute a part of this specification, illustrate examples of the invention and together with the description serve to explain the principles of the invention. In the drawings:
FIG. 1 shows an entire shape of a solar cell module according to an example of the invention;
FIG. 2 is a cross-sectional view schematically showing a solar cell shown in FIG. 1;
FIG. 3 shows an entire shape of a wiring member of the solar cell module shown in FIG. 1;
FIG. 4 is a cross-sectional view of a wiring member shown in FIG. 3;
FIG. 5 shows another wiring member according to an example of the invention;
FIG. 6 is a cross-sectional view of a wiring member shown in FIG. 5;
FIG. 7 shows a buffer formed on a wiring member;
FIG. 8 shows a connection relationship between electrodes of each solar cell and wiring members in the solar cell module shown in FIG. 1;
FIG. 9 is a cross-sectional view taken along line I-I' of FIG. 8;
FIG. 10 is a cross-sectional view taken along line II-II' of FIG. 8;
FIG. 11 shows that a pad is formed at a crossing of an electrode and a wiring member;
FIG. 12 is a cross-sectional view taken along line III-III' of FIG. 11;
FIG. 13 shows that a pad is configured as a layer different from an electrode;
FIG. 14 shows that a pad further includes a slit;
FIGS. 15 and 16 show that the size of a pad varies depending on a position;
FIG. 17 shows an electrode including a disconnection portion;
FIG. 18 shows that a width of a disconnection portion varies depending on a position;
FIG. 19 shows a disconnection portion including a bank;
FIG. 20 is a cross-sectional view taken along line IV-IV' of FIG. 19;
FIG. 21 shows a connection electrode for electrically connecting a pad;
FIG. 22 is a cross-sectional view taken along line V-V' of FIG. 21;
FIG. 23 is a flow chart showing a method for manufacturing a solar cell module not forming part of the present invention;
FIG. 24 shows a dispersion layer positioned between a conductive layer and an insulating layer;
FIG. 25 is a cross-sectional view taken along line VI-VI' of FIG. 24;
FIG. 26 shows a dispersion layer formed in an electrode including a disconnection portion;
FIG. 27 is a cross-sectional view taken along line VII-VII' of FIG. 26;
FIG. 28 shows an example where a dispersion layer is formed in the plural;
FIG. 29 is a prospective view of a solar cell module including solar cells of a conventional structure;
FIG. 30 is a cross-sectional view taken along line A-A of FIG. 29;
FIG. 31 is a cross-sectional view taken along line B-B of FIG. 29;
FIG. 32 shows a wiring member;
FIG. 33 shows a first example of a first electrode;
FIG. 34 shows a second example of a first electrode;
FIG. 35 shows a third example of a first electrode;
FIG. 36 shows a fourth example of a first electrode;
FIG. 37 shows a fifth example of a first electrode;
FIG. 38 shows a sixth example of a first electrode;
FIG. 39 shows a seventh example of a first electrode;
FIG. 40 shows that a first electrode includes an extension pad and an auxiliary pad according to the present invention;
FIG. 41 shows that a second electrode includes an extension pad and an auxiliary pad according to the present invention;
FIG. 42 shows that a solar cell module including solar cells of a conventional structure includes a reflector;
FIG. 43 is a cross-sectional view taken along line A-A of FIG. 42;
FIG. 44 is a cross-sectional view taken along line B-B of FIG. 42;
FIG. 45 shows a wiring member of a solar cell module shown in FIG. 42;
FIG. 46 shows a first electrode of a solar cell module shown in FIG. 42;
FIG. 47 shows a second electrode of a solar cell module shown in FIG. 42;
FIGS. 48 to 51 show a position relationship between a front pad and a back pad;
FIG. 52 shows a reflector of a solar cell module shown in FIG. 42;
FIG. 53 is a cross-sectional view taken along line C-C of FIG. 52; and
FIGS. 54 to 58 show various structures of a reflector along line C-C of FIG. 52.

### DETAILED DESCRIPTION OF THE EMBODIMENTS

Reference will now be made in detail to embodiments of the invention, examples of which are illustrated in the accompanying drawings. This invention may, however, be embodied in many different forms and should not be construed as limited to the embodiments set forth herein. Wherever possible, the same reference numbers will be used throughout the drawings to refer to the same or like parts. It will be paid attention that detailed description of known arts will be omitted if it is determined that the detailed description of the known arts can lead to misconstruing of the examples of the invention.

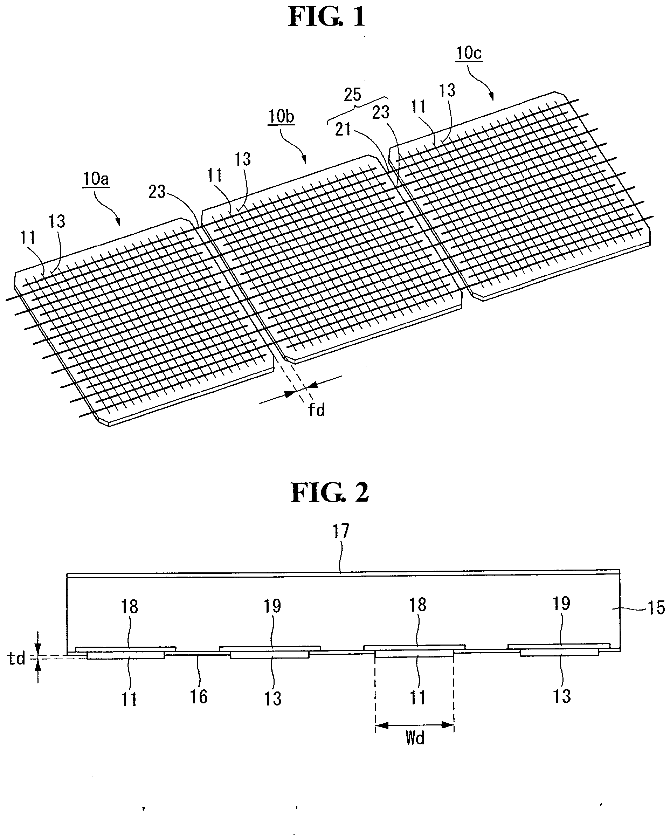

FIG. 1 shows an entire shape of a solar cell module according to an example of the invention. More specifically, FIG. 1 shows the solar cell module including three adjacent solar cells, which are connected to one another in a horizontal direction.

As shown in FIG. 1, each of solar cells 10a to 10c has a regular hexahedron shape having a thin thickness. Each solar cell includes first conductive type electrodes (hereinafter, referred to as "first electrodes") 11 and second conductive type electrodes (hereinafter, referred to as "second electrodes") 13, which are formed on a back surface of the solar cell and dividedly collect electrons and holes.

The first and second electrodes 11 and 13 are alternately positioned on a back surface of a semiconductor substrate 15 in parallel with each other in a first direction. For example, as shown in FIG. 1, the first electrodes 11 extend in a vertical direction and are arranged in parallel with one another, and the second electrodes 13 extend in the vertical direction and are arranged in parallel with one another. The first and second electrodes 11 and 13 are alternately arranged in a horizontal direction and are separated from each other by a uniform distance.

The first electrode 11 and the second electrode 13 are electrically connected to a wiring member 25 and thus are connected to the second electrode 13 and the first electrode 11 of another solar cell adjacent to the solar cell.

The wiring member 25 is disposed in the horizontal direction (for example, the second direction) crossing the vertical direction (for example, the first direction) of the first and second electrodes 11 and 13 and electrically connects the two adjacent solar cells, thereby connecting the plurality of solar cells 10a to 10c in series. The solar cells 10a to 10c may be connected in series or in parallel to one another. In the following description, the solar cell module, in which the solar cells 10a to 10c are connected in series to one another, is described as an example.

The wiring member 25 includes a first wiring member 21 and a second wiring member 23. The configuration is described using the second solar cell 10b, which is positioned in the middle, as an example. Namely, the first wiring member 21 is electrically connected to the first electrodes 11 and is insulated from the second electrodes 13, and the second wiring member 23 is electrically connected to the second electrodes 13 and is insulated from the first electrodes 11.

More specifically, one side of the first wiring member 21 is electrically connected to the first electrodes 11 of the second solar cell 10b, and the other side is electrically connected to the second electrodes 13 of the third solar cell 10c adjacent to the second solar cell 10b, thereby connecting the second solar cell 10b to the third solar cell 10c. Further, one side of the second wiring member 23 is electrically connected to the second electrodes 13 of the second solar cell 10b, and the other side is electrically connected to the first electrodes 11 of the first solar cell 10a adjacent to the second solar cell 10b, thereby connecting the second solar cell 10b to the first solar cell 10a.

The first wiring members 21 and the second wiring members 23 are alternately arranged in the vertical direction and are positioned in parallel with each other.

As described above, because the wiring members 25 are disposed in a direction crossing the electrodes 11 and 13, it is easy to connect the wiring members 25 to the electrodes 11 and 13, and also the alignment between the wiring members 25 and the electrodes 11 and 13 becomes easy. In the example of the invention, the first and second electrodes 11 and 13 are formed on the back surface of the solar cell in parallel with each other, and the wiring members 25 are connected to the first and second electrodes 11 and 13 in the direction crossing the first and second electrodes 11 and 13. Therefore, a thermal deformation direction of the wiring members 25 and a thermal deformation direction of the first and second electrodes 11 and 13 cross each other. Hence, the solar cell may be protected from a latent stress resulting from the thermal deformation.

FIG. 2 is a cross-sectional view schematically showing the solar cell shown in FIG. 1. As shown in FIG. 2, the solar cell according to the example of the invention is a back contact solar cell, in which all of the first and second electrodes 11 and 13 are positioned on the back surface of the semiconductor substrate 15 of a first conductive type (for example, a p-type or an n-type).

Thin layers 16 and 17, which prevent the reflection of light and perform a passivation function, are respectively formed on a front surface (on which light is incident) and the back surface (positioned opposite the front surface) of the semiconductor substrate 15.

A thin emitter region 18 and a thin back surface field region 19, each of which reduces a potential barrier, are respectively formed between the first electrode 11 and the semiconductor substrate 15 and between the second electrode 13 and the semiconductor substrate 15 and may make it easy for carriers to be collected by the electrodes 11 and 13.

The solar cell has a square plane shape of 180 mm or less by 180 mm or less, and a thickness of the solar cell is equal or less than 250 µm. Namely, the solar cell has a very thin plate shape. Thus, the solar cell of the thin plate shape may be weak to thermal deformation. In particular, the solar cell may have a latent stress resulting from the thermal deformation due to the first and second electrodes 11 and 13 having a thermal expansion coefficient different from the semiconductor substrate 15. Hence, the solar cell may be physically broken or may be bent.

However, the example of the invention increases a width Wd of each of the first and second electrodes 11 and 13 and reduces a thickness td of each of the first and second electrodes 11 and 13, as compared to a related art, thereby solving the problem resulting from the thermal deformation. According to an experiment, when the width Wd of the electrode was 100 µm to 600 µm and the thickness td of the electrode was 0.1 µm to 10.0 µm, carriers could be stably collected and the above-described problem could be solved.

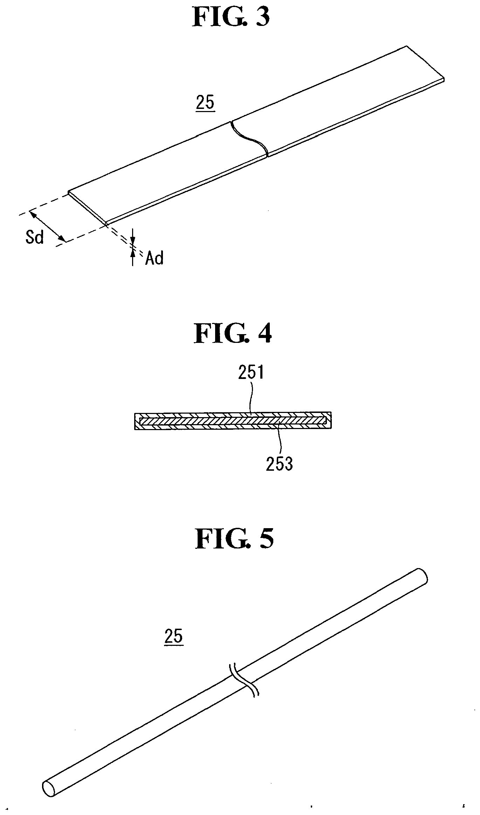

FIG. 3 shows an entire shape of the wiring member of the solar cell module shown in FIG. 1, and FIG. 4 is a cross-sectional view of the wiring member shown in FIG. 3. As shown in FIGS. 3 and 4, the wiring member 25 has a rectangular band shape having a thin thickness and has a rectangular cross section. Further, the wiring member 25 has a width Sd of 1.0 mm to 50 mm and a thickness Ad of 25 µm to 200 µm.

Because the wiring member 25 is connected to the electrodes 11 and 13, the thermal deformation of the wiring member 25 may be transferred to the solar cells 10a to 10c if the wiring member 25 is thermally deformed. Hence, the solar cells 10a to 10c may be deformed. However, the example of the invention may minimize the thermal deformation through a reduction in the thickness Ad of the wiring member 25 and also may smoothly perform the transfer of carriers through an increase in the width Sd of the wiring member 25.

As shown in FIG. 4, the wiring member 25 includes a coating layer 251 forming the surface and a core layer 253 which is coated with the coating layer 251 at a thin thickness, for example, 15 µm to 35 µm. The core layer 253 may be formed of a metal material with good conductivity, for example, Ni, Cu, Ag, and Al. The coating layer 251 may be formed of Pb, Sn, or a solder having a chemical formula indicated by SnIn, SnBi, SnPb, SnCuAg, and SnCu, or a combination thereof.

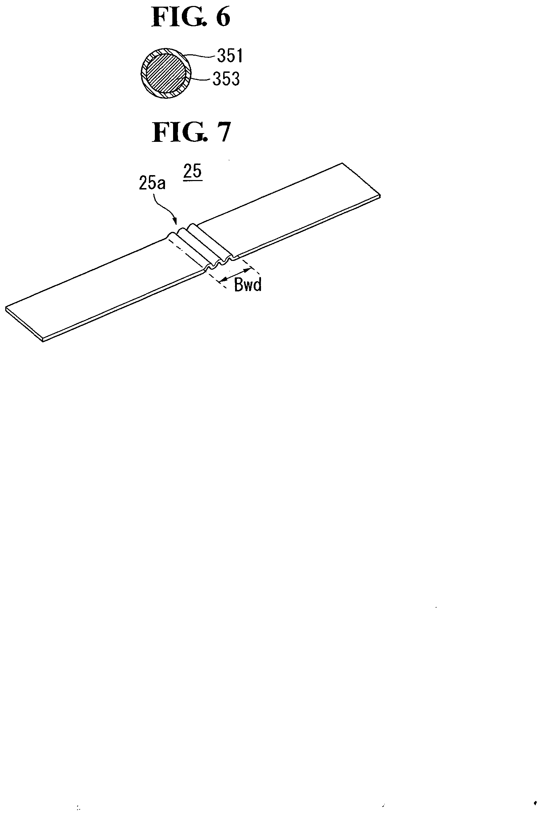

FIG. 5 shows another wiring member according to the example of the invention, and FIG. 6 is a cross-sectional view of the wiring member shown in FIG. 5. As shown in FIGS. 5 and 6, a wiring member 25 has a wire shape having a circular cross section. The wiring member 25 includes a coating layer 351 and a core layer 353 and has a diameter of 250 µm to 500 µm. As described above, because the wiring member 25 has the circular cross section, thermal deformation resulting from the circular wiring member 25 may further decrease as compared to the wiring member 25 shown in FIG. 3.

FIGS. 3 and 5 respectively show the rectangular wiring member and the circular wiring member, as an example. The wiring member may have a polygon or a curved shape.

The wiring member 25 having the above-described configuration may further include a buffer. FIG. 7 shows an example where a buffer is formed on the band-shaped wiring member shown in FIG. 3.

As shown in FIG. 7, a buffer 25a is configured so that the wiring member 25 may stretch in a longitudinal direction. The buffer 25a is configured so that a real length of the buffer 25a is longer than a width Bwd of the buffer 25a, and thus may have any shape as long as it may stretch. For example, the buffer 25a may have a twisted shape like a coil, or a wrinkle shape having peaks and valleys. FIG. 7 shows the buffer 25a of the wrinkle shape, in which the real length of the buffer 25a is longer than the width Bwd of the buffer 25a, as an example.

Further, the width Bwd of the buffer 25a has to be equal to or less than a distance between the solar cells. As shown in FIG. 1, the plurality of solar cells are positioned at a regular distance fd and are connected to one another through the wiring members 25. The buffer 25a is positioned between the solar cells. Thus, even if the distance between the solar cells connected through the wiring members 25 increases, the buffer 25a may stretch suitably for the increased distance. Hence, the wiring member 25 may be prevented from being broken because of a stress applied to the wiring member 25, and the solar cell module may be protected from a physical impact, such as a damage of a connection portion between the wiring member 25 and the first and second electrodes 11 and 13. Thus, the width Bwd of the buffer 25a has to be equal to or less than the distance fd between the solar cells.

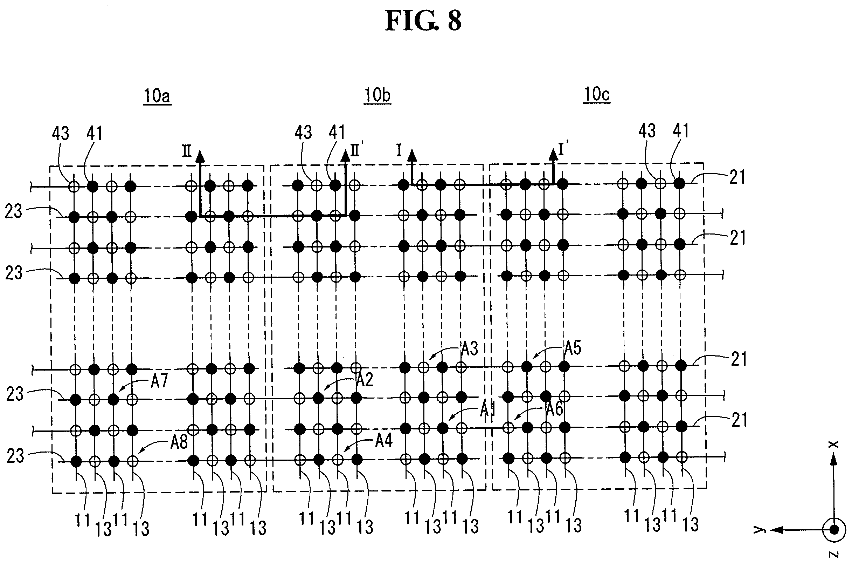

Hereinafter, an electrical connection relationship between the electrodes of each solar cell and the wiring members is described with reference to FIGS. 8 to 10.

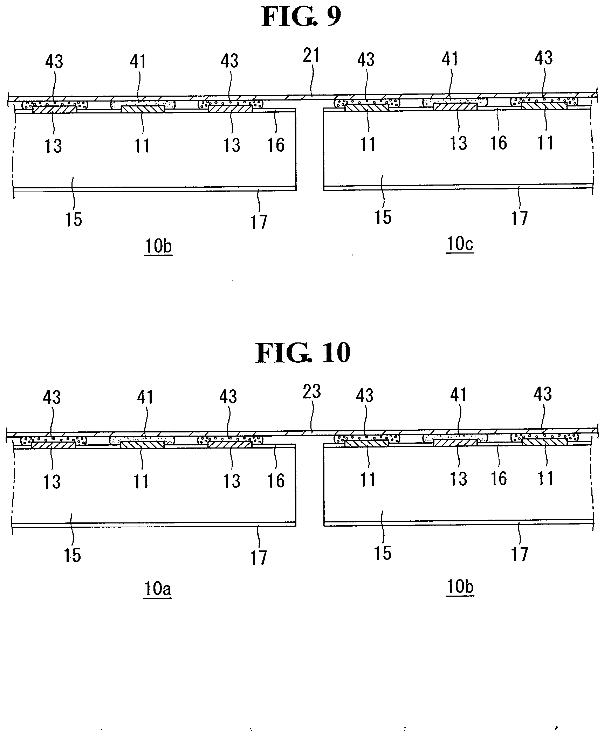

FIG. 8 shows a connection relationship between the electrodes of each solar cell and the wiring members in the solar cell module shown in FIG. 1. FIG. 9 is a cross-sectional view taken along line I-I' of FIG. 8. FIG. 10 is a cross-sectional view taken along line II-II' of FIG. 8.

As shown in FIGS. 8 to 10, in each of the solar cells 10a to 10c, the first electrodes 11 extend in parallel with one another, and the second electrodes 13 extend in parallel with one another. Further, the first and second electrodes 11 and 13 are alternately arranged in the vertical direction (for example, the y-axis direction in the drawings).

In the same manner as the first and second electrodes 11 and 13, the first wiring members 21 extend in parallel with one another, and the second wiring members 23 extend in parallel with one another. Further, the first and second wiring members 21 and 23 are alternately arranged in the horizontal direction (for example, the x-axis direction in the drawings).

As described above, in each of the solar cells 10a to 10c, the first and second electrodes 11 and 13 are alternately arranged, and the first and second wiring members 21 and 23 are alternately arranged. The first electrode 11 and the second electrode 13 respectively collect carriers of a first conductive type and carriers of a second conductive type opposite the first conductive type, and the first and second wiring members 21 and 23 transfer carriers of different conductive types. In the example of the invention, because the electrodes and the wiring members each have the alternate arrangement structure, each solar cell may uniformly collect and transfer the carriers throughout the solar cell.

The first wiring members 21 are disposed on the second solar cell 10b and the third solar cell 10c and electrically connect the second solar cell 10b to the third solar cell 10c. The second wiring members 23 are disposed on the first solar cell 10a and the second solar cell 10b and electrically connect the first solar cell 10a to the second solar cell 10b.

In each of the solar cells 10a to 10c, a conductive layer 41 and an insulating layer 43 are positioned between the first and second wiring members 21 and 23 and between the first and second electrodes 11 and 13, thereby selectively connecting the wiring member and the electrode or selectively disconnecting the wiring members and the electrodes.

The conductive layer 41 is configured such that conductive particles are included in an epoxy-based synthetic resin or a silicon-based synthetic resin. Thus, the conductive layer 41 has the adhesion and the conductivity. The conductive particles may be formed of Ni, Al, Ag, Cu, Pb, Sn, or a metal material having a chemical formula indicated by SnIn, SnBi, SnPb, SnCuAg, SnCu, or a compound including at least two of the above materials. The conductive layer 41 may be formed of tin (Sn) alloy not including a synthetic resin, for example, tin (Sn) alloy having a chemical formula indicated by SnIn, SnBi, SnPb, SnCuAg, and SnCu.

The conductive layer 41 may be formed of a solder paste. The solder paste is a paste including solder particles containing Pb or Sn and melts and combines two basic materials while melting the solder particles existing in the solder paste when heat equal to or higher than a melting temperature is applied to the solder paste.

The conductive layer 41 formed thus electrically connects the first wiring member 21 or the second wiring member 23 and the first electrode 11 or the second electrode 13.

The insulating layer 43 is formed of an insulating material with the adhesion, such as an epoxy-based synthetic resin, a silicon-based synthetic resin, and ceramic. The insulating layer 43 prevents the electrical connection between the first wiring member 21 and the first electrode 11 or the second electrode 13.

In the second solar cell 10b, the conductive layer 41 is positioned in a first area A1 where the first wiring member 21 and the first electrode 11 cross each other, and a second area A2 where the second wiring member 23 and the second electrode 13 cross each other, thereby electrically connecting them.

Further, in the second solar cell 10b, the insulating layer 43 is positioned in a third area A3 where the first wiring member 21 and the second electrode 13 cross each other, and a fourth area A4 where the second wiring member 23 and the first electrode 11 cross each other, thereby electrically disconnecting them.

Hence, the first wiring member 21 is electrically connected to the first electrode 11 of the second solar cell 10b and is insulated from the second electrode 13 of the second solar cell 10b.

In the third solar cell 10c, the conductive layer 41 is positioned in a fifth area A5 where the first wiring member 21 and the second electrode 13 cross each other, and the insulating layer 43 is positioned in a sixth area A6 where the first wiring member 21 and the first electrode 11 cross each other. Hence, the first wiring member 21 is electrically connected to the second electrode 13 of the third solar cell 10c and is insulated from the first electrode 11 of the third solar cell 10c.

As a result, the first wiring member 21 is electrically connected to the first electrode 11 of the second solar cell 10b and the second electrode 13 of the third solar cell 10c, thereby electrically connecting the second solar cell 10b to the third solar cell 10c (refer to FIG. 9).

Further, in the first solar cell 10a, the conductive layer 41 is positioned in a seventh area A7 where the second wiring member 23 and the first electrode 11 cross each other, and the insulating layer 43 is positioned in an eighth area A8 where the second wiring member 23 and the second electrode 13 cross each other. Hence, the second wiring member 23 is electrically connected to the first electrode 11 of the first solar cell 10a and is insulated from the second electrode 13 of the first solar cell 10a.

As a result, the second wiring member 23 is electrically connected to the second electrode 13 of the second solar cell 10b and the first electrode 11 of the first solar cell 10a, thereby electrically connecting the second solar cell 10b to the first solar cell 10a (refer to FIG. 10).

As described above, at least one first wiring member 21 and at least one second wiring member 23 are necessary in one solar cell, as the wiring member, which is connected to or insulated from the electrode through the conductive layer 41 and the insulating layer 43. Up to 20 first wiring members 21 and up to 20 second wiring members 23 are necessary in one solar cell. However, the number of wiring members may be properly adjusted depending on the size of the solar cell, the size of the electrode, the size of the wiring member, etc.

The first wiring members 21 and the second wiring members 23 connect two solar cells (for example, the first and third solar cells 10a and 10c) adjacent to one solar cell (for example, the second solar cell 10b) to the one solar cell. Therefore, ends of the first wiring members 21 are collected at a left edge of the second solar cell 10b, and ends of the second wiring members 23 are collected at a right edge of the second solar cell 10b. The number of each of the first and second wiring members 21 and 23 in one solar cell is one half of the total number of wiring members 25.

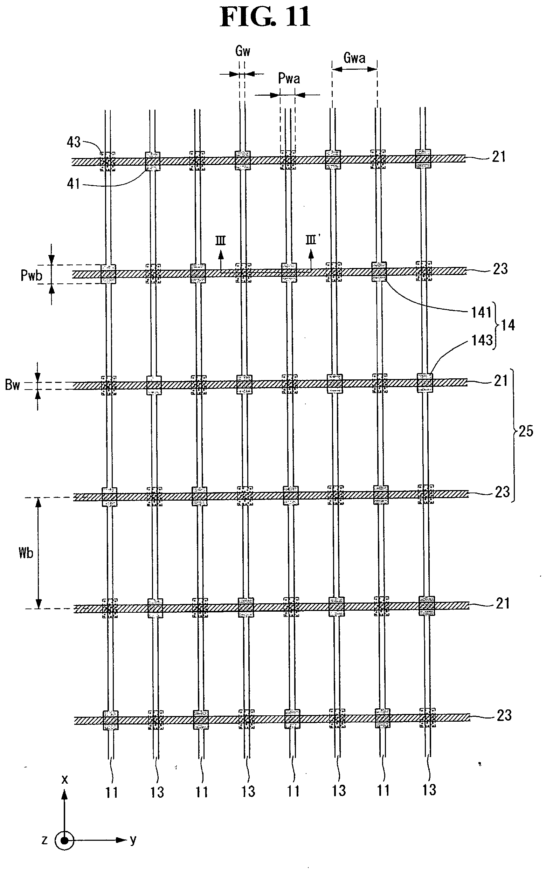

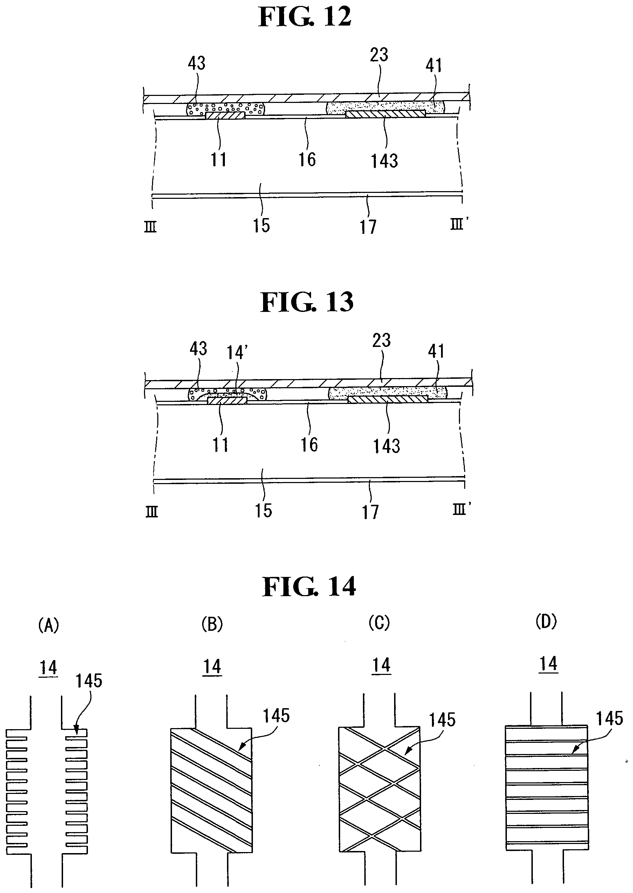

FIG. 11 shows that a pad 14 is formed at crossings of the electrodes 11 and 13 and the wiring member 25, and FIG. 12 is a cross-sectional view taken along line III-III' of FIG. 11. In the following description, the example of the invention is described using the second solar cell 10b as an example.

As described above, the conductive layer 41 is positioned in an electrical connection portion of the electrodes 11 and 13 and the wiring member 25, thereby electrically connecting the first wiring member 21 to the first electrode 11 and electrically connecting the second wiring member 23 to the second electrode 13.

Further, the insulating layer 43 is positioned in a non-connection portion of the electrodes 11 and 13 and the wiring member 25, thereby insulating the first wiring member 21 from the second electrode 13 and insulating the second wiring member 23 from the first electrode 11.

The pad 14 is formed in the connection portion of the electrodes 11 and 13 and the wiring member 25 in each solar cell and includes first pads 141 and second pads 143. The first pads 141 are formed in a portion (i.e., electrical connection portion) of the first electrode 11 among crossings of the first wiring members 21 and the first electrodes 11, and the second pads 143 are formed in a portion (i.e., electrical connection portion) of the second electrode 13 among crossings of the second wiring members 23 and the second electrodes 13.

The pad 14 helps in electrically connecting the first and second electrodes 11 and 13 to the wiring member 25 through the conductive layer 41. Further, the pad 14 increases a crossing area of the electrodes 11 and 13 and the wiring member 25 when carriers collected by the electrodes 11 and 13 are transferred to the wiring member 25, and reduces a surface resistance, thereby reducing a loss of carriers.

The example of the invention described that the pad 14 is formed of the same material as the electrodes 11 and 13 and is configured as a part of the electrodes 11 and 13, but is not limited thereto. For example, as shown in FIG. 13, the pad 14 may be formed of a conductive material different from the electrodes 11 and 13, or the conductive layer 41 may be configured as the pad 14.

A horizontal width Pwa of the pad 14 is less than a distance Gwa between the first and second electrodes 11 and 13 and is greater than a width Gw of each of the first and second electrodes 11 and 13. Further, a vertical width Pwb of the pad 14 is less than a distance Wb between the first and second wiring members 21 and 23 and is greater than a width Bw of each of the first and second wiring members 21 and 23.

If the horizontal width Pwa of the pad 14 is greater than the distance Gwa between the first and second electrodes 11 and 13, the adjacent electrodes may contact each other because of the pad 14. Hence, the short circuit of the adjacent electrodes may be generated. When the horizontal width Pwa of the pad 14 is greater than the width Gw of the electrode, the pad 14 may be stably configured. Further, if the vertical width Pwb of the pad 14 is greater than the distance Wb between the first and second wiring members 21 and 23, the adjacent pads may contact each other. Hence, the short circuit of the adjacent electrodes may be generated. When the vertical width Pwb of the pad 14 is greater than the width Bw of the wiring member, the wiring member may be stably connected to the electrode.

FIG. 13 shows that a pad 14' is configured as a layer different from the electrode. The pad 14' shown in FIG. 13 is formed on the electrode and is configured as a layer different from the electrode, unlike the above-described pad 14.

The pad 14' shown in FIG. 13 may be formed through a screen printing method, an inkjet method, a dispensing method, etc., and has a thickness of 1 µm to 20 µm. The pad 14' may be formed of Ni, Al, Ag, Cu, Pb, Sn, or a metal material having a chemical formula indicated by SnIn, SnBi, SnPb, SnCuAg, SnCu, or a compound including at least two of the above materials. For example, the pad 14' may be formed of the same material as the conductive layer 41.

In the example of the invention, because the pad 14' is positioned between the electrodes 11 and 13 and the conductive layer 41 or between the electrodes 11 and 13 and the insulating layer 43, a design freedom may increase.

Namely, if the pad 14' is not formed or is configured as a part of the electrode, a material forming the conductive layer 41 or the insulating layer 43 cannot help being selected based on the electrode. However, because the electrodes have been already made at the substrate, it is difficult to change a formation material of the electrodes.

On the contrary, when the pad 14' is configured as the layer different from the electrode as shown in FIG. 13, the material forming the conductive layer 41 or the insulating layer 43 may be selected based on the pad 14'. Because the pad 14' has not been made at the substrate unlike the electrode, a formation material of the pad 14' may vary, if necessary or desired. As a result, a selection width of the material forming the conductive layer 41 or the insulating layer 43 may widen.

For example, if the electrodes 11 and 13 are formed of Niv, it is difficult to use the solder formed of tin (Sn) or Sn-alloy as the material of the conductive layer when there is no pad 14'. However, when the pad 14' is formed of one of Cu, Ag, and Au, the solder formed of tin (Sn) or Sn-alloy may be used as the material of the conductive layer.

FIG. 14 shows that the pad further includes a slit. As shown in FIG. 14, at least one of the first and second pads 14 may include slits 145 each having a thin groove. The slit 145 is formed along the longitudinal direction of the wiring member and is in the plural in a left-right symmetric manner about a central line of the wiring member. Hence, as shown in (A) of FIG. 14, the slits 145 of the pad 14 may entirely have a comb shape.

In FIG. 14, (A) shows that the slits 141 are formed along the longitudinal direction of the wiring member; (B) shows that the slits 141 are formed along an oblique direction of the wiring member; (C) shows that the slits 141 are formed in a diamond shape; and (D) shows that the slits 141 are formed in a lattice shape. Alternatively, the slits 141 may be formed without a regular pattern.

When the pad 14 further includes the slit, an application amount of the conductive layer 41 may increase if the conductive layer 41 is formed on the pad 14. Hence, the connection strength and the conductivity may increase. Further, even if the size of the electrode increases due to the pad 14, a recombination and/or a disappearance of carriers at the pad 14 may be prevented because a real cross-sectional area of the electrode does not increase.

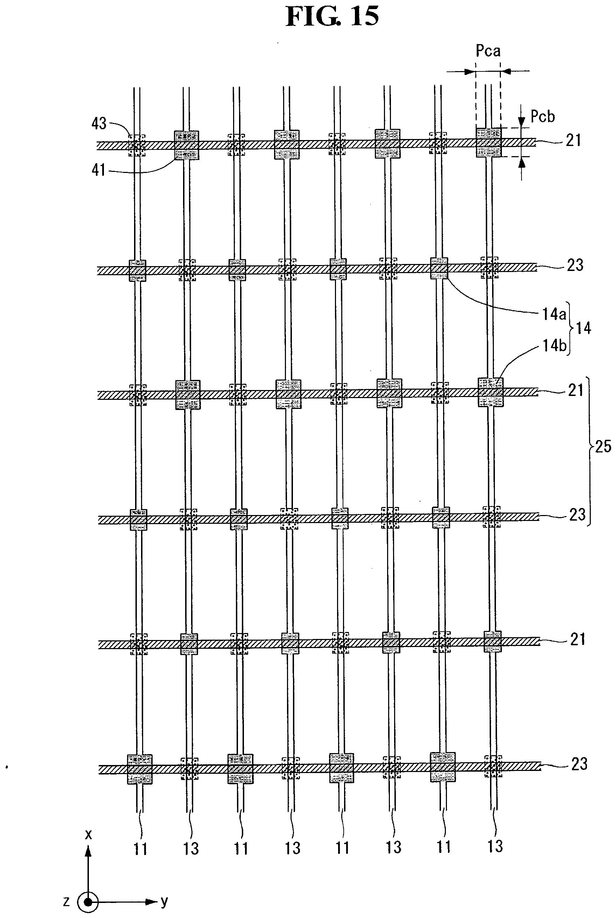

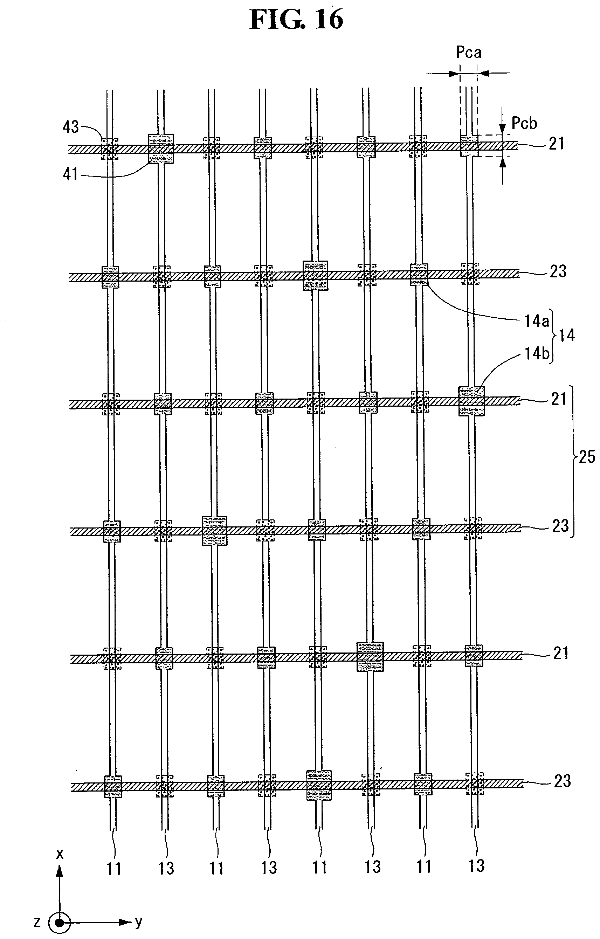

FIGS. 15 and 16 show that the size of the pad 14 varies depending on a position. More specifically, FIG. 15 shows that all of the pads of one line in the longitudinal direction of the wiring member 25 are larger than all of the pads of another line. FIG. 16 shows that only one of the pads of each line is larger than the remaining pads of each line. In the example of the invention, at least one of the pads 14 may have the size different from the remaining pads 14. More specifically, the first pad 141 or the second pad 142 may include a first contact pad 14a having a width greater than the width of each of the first and second electrodes 11 and 13 and a second contact pad 14b larger than the first contact pad 14a.

The size of the pad 14 includes a case where a two-dimensional area is different from a three-dimensional volume. FIG. 15, which is the plane view of the electrode, shows different bonding areas, in which the wiring member 25 is electrically connected to the pad 14 through the conductive layer 41.

In FIG. 15, an area of the second contact pad 14b is larger than an area of the first contact pad 14a. A simple method capable of increasing the area is to increase a horizontal width Pca or a vertical width (or a length) Pcb of the second contact pad 14b further than a horizontal width or a vertical width of the first contact pad 14a. FIG. 15 shows that both the horizontal width Pca and the vertical width Pcb of the second contact pad 14b are greater than the horizontal width and the vertical width of the first contact pad 14a, as an example.

Because the solar cell has to be entirely exposed at a high temperature so as to connect the electrodes 11 and 13 to the pad 14, the solar cell may be bent in a process for connecting the electrodes 11 and 13 and the pad 14. However, in the example of the invention, because the size of the second contact pad 14b is larger than the size of the first contact pad 14a, the wiring member 25 is first attached to the second contact pad 14b. After a predetermined period of time passed, the wiring member 25 is attached to the first contact pad 14a. Namely, because the solar cell is exposed at the high temperature at an interval of the predetermined period of time, the bending of the substrate may be reduced. The second contact pad 14b may further improve a physical adhesive strength and a contact resistance between the wiring member 25 and the first and second electrodes 11 and 13.

In a manufacturing process, the wiring member 25 is fixed through a thermal process in a state where the wiring member 25 is placed on a liquid conductive layer. However, because the conductive layer is a liquid layer, the wiring member 25 may be bent during the thermal process. On the other hand, in the example of the invention, because the wiring member 25 is first fixed to the second contact pad 14b and then may be fixed to the first contact pad 14a through the thermal process, the bending of the wiring member 25 may be prevented.

In the example of the invention, the wiring member 25 is heated at a temperature less than a curing temperature capable of curing the conductive layer or the insulating layer and is temporarily fixed to the second contact pad 14b. Afterwards, the wiring member 25 is heated at a temperature equal to or higher than the curing temperature and is connected to the electrode. Thus, it is preferable, but not required, that the number of temporarily fixed second contact pads 14b is less than the number of first contact pads 14a.

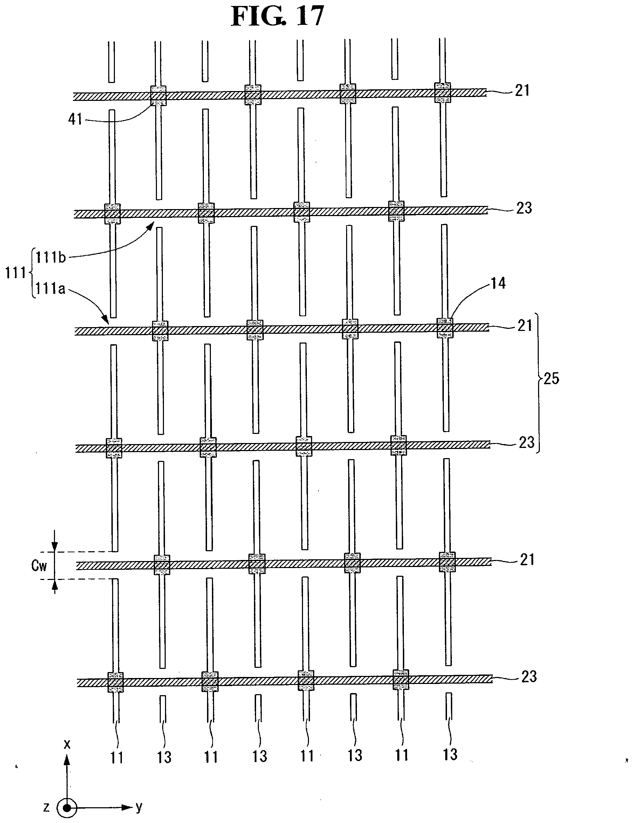

FIG. 17 shows that each of the electrodes 11 and 13 further includes a disconnection portion.

As shown in FIG. 17, at least a portion of the second electrodes 13 insulated from the first wiring member 21 or at least a portion of the first electrodes 11 insulated from the second wiring member 23 in the solar cell module according to the example of the invention may include a disconnection portion 111, in which the electrode does not exist (or is missing) by partially cutting off (or not forming) the electrode.

In the example of the invention, the disconnection portion 111 is a portion, in which the electrode is cut off and does not exist. Each of the electrodes 11 and 13 is cut off by a predetermined width Cw in its longitudinal direction. Thus, each of the electrodes 11 and 13 is absent by the predetermined width Cw.

The disconnection portion 111 is formed along non-connection portions and includes a first disconnection portion 111a and a second disconnection portion 111b. The first disconnection portion 111a is formed in the non-connection portions of the first electrode 11, and the second disconnection portion 111b is formed in the non-connection portions of the second electrode 13. The first disconnection portion 111a and the second disconnection portion 111b are alternatingly arranged, and are not aligned.

The disconnection portion 111 blocks a physical contact between the electrodes 11 and 13 and the wiring member 25 in the non-connection portions and thus blocks any electrical connection between them. A width Cw of the disconnection portion 111 has to be greater than the width Bw of the wiring member 25.

Because the disconnection portion 111 is formed in the non-connection portion between the electrodes 11 and 13 and the wiring member 25, the disconnection portion 111 does not affect the efficiency of the solar cell even if the electrode includes the disconnection portion 111.

As described above, because the electrodes 11 and 13 are not physically connected to the wiring member 25 in the non-connection portions when each of the electrodes 11 and 13 includes the disconnection portion 111, the insulating layer 43 does not need to be formed in the non-connection portions. Hence, the manufacturing yield may increase, and the manufacturing cost may be reduced.

FIG. 17 shows that all of the second electrodes 13 insulated from the first wiring members 21 and the first electrodes 11 insulated from the second wiring members 23 include the disconnection portion 111, as an example. However, only a portion of the second electrodes 13 insulated from the first wiring members 21 and only a portion of the first electrodes 11 insulated from the second wiring members 23 may include the disconnection portion 111. The insulating layer 43 may be formed in the remaining portion of the first and second electrodes 11 and 13. Hence, the first wiring members 21 and the second electrodes 13 may be insulated through the insulating layer 43, and the second wiring members 23 and the first electrodes 11 may be insulated through the insulating layer 43.

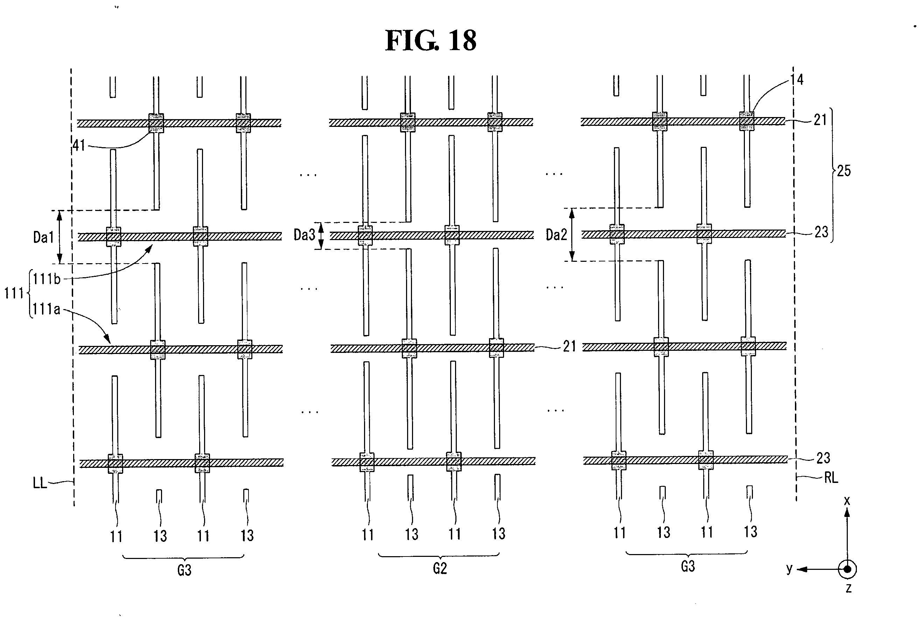

FIG. 18 shows that a width of the disconnection portion varies depending on a position.

In FIG. 18, it is assumed that the electrodes 11 and 13 belonging to a first group G1 indicate the electrodes positioned adjacent to a left side LL of the solar cell in the longitudinal direction of the wiring member 25; the electrodes 11 and 13 belonging to a second group G2 indicate the electrodes positioned adjacent to a right side RL of the solar cell in the longitudinal direction of the wiring member 25; and the electrodes 11 and 13 belonging to a third group G3 indicate the electrodes positioned between the first group G1 and the second group G2, i.e., in the middle of the solar cell.

In the example of the invention, the disconnection portion 111 includes a first long disconnection portion 113 formed at the electrodes 11 and 13 belonging to the first group G1, a second long disconnection portion 115 formed at the electrodes 11 and 13 belonging to the second group G2, and a short disconnection portion 117 formed at the electrodes 11 and 13 belonging to the third group G3.

The first long disconnection portion 113 separates the electrodes from each other by a first distance Da1 in the longitudinal direction of the electrode; the second long disconnection portion 115 separates the electrodes from each other by a second distance Da2 in the longitudinal direction of the electrode; and the short disconnection portion 117 separates the electrodes from each other by a third distance Da3 in the longitudinal direction of the electrode.
It is preferable, but not required, that the first distance Da1 and the second distance Da2 are the same as each other and is greater than the third distance Da3. Further, it is preferable, but not required, that the third distance Da3 is greater than the width of the wiring member 25, and the first distance Da1 and the second distance Da2 are less than a distance between the first and second wiring members 21 and 23.

As described above, the disconnection portion 111 includes the first long disconnection portion 113, the second long disconnection portion 115, and the short disconnection portion 117, each of which has the different electrode separation distance depending on the position. Therefore, when the wiring member 25 is fixed to the solar cells 10a to 10c, short circuit resulting from the bending of the wiring member 25 and a contact between the wiring member 25 and the electrode in the non-connection portion may be prevented due to a margin corresponding to a difference between the first distance Da1 and the third distance Da3.

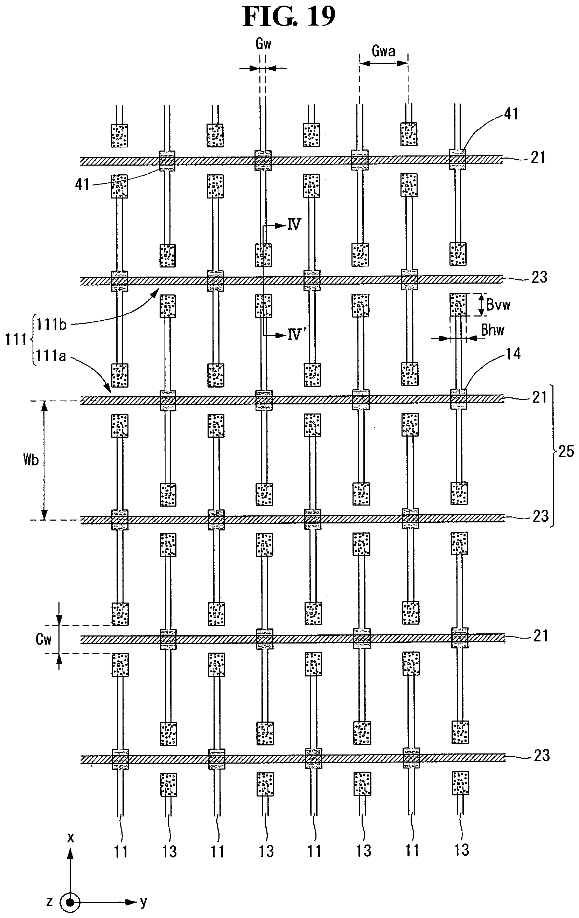

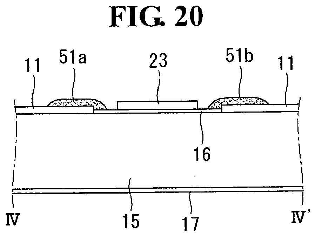

FIG. 19 shows the disconnection portion including (or contacting) a bank, and FIG. 20 is a cross-sectional view taken along line IV-IV' of FIG. 19. In the example of the invention, a bank 51 means an insulating material selectively covering an end of the electrodes 11 and 13 including (or being disposed or positioned on) the disconnection portion 111. The bank 51 includes a first bank 51a and a second bank 51b. The first bank 51a and the second bank 51b are formed in an island shape on and under the wiring member 25. Namely, the first bank 51a is positioned on the wiring member 25, and the second bank 51b is positioned under the wiring member 25.

The bank 51 formed in a pair is positioned at an end of the electrode forming the disconnection portion 111 and has a cross-sectional shape covering the end of the electrode. Thus, the wiring member 25 across the disconnection portion 111 is positioned between the first bank 51a and the second bank 51b. Hence, the bank 51 may prevent the physical contact between the wiring member 25 and the electrodes 11 and 13 resulting from the misalignment.

A horizontal width Bhw of the bank 51 has to be greater than a width Gw of the electrodes 11 and 13 and has to be less than a distance Gwa between the electrodes 11 and 13. Further, a vertical width Bvw of the bank 51 has to be less than a distance Wb between the wiring members.

When the horizontal width Bhw of the bank 51 is greater than the width Gw of the electrodes 11 and 13, the bank 51 covers the electrodes 11 and 13 in the horizontal direction. Hence, the bank 51 may prevent the physical contact between the wiring member 25 and the electrodes 11 and 13. When the horizontal width Bhw of the bank 51 is greater than the distance Gwa between the electrodes 11 and 13, the bank 51 may be formed at the pad 14 adjacent to the disconnection portion 111 in the vertical direction. Hence, the bank 51 may prevent the physical contact between the pad 14 and the wiring member 25 in a connection portion.

The bank 51 may be formed of the same material as the insulating layer 43 or a material different from the insulating layer 43. FIGS. 19 and 20 shows that the plane shape of the bank 51 is a quadrangle, as an example. Other shapes may be used for the bank 51. For example, the plane shape of the bank 51 may be a circle or an oval.

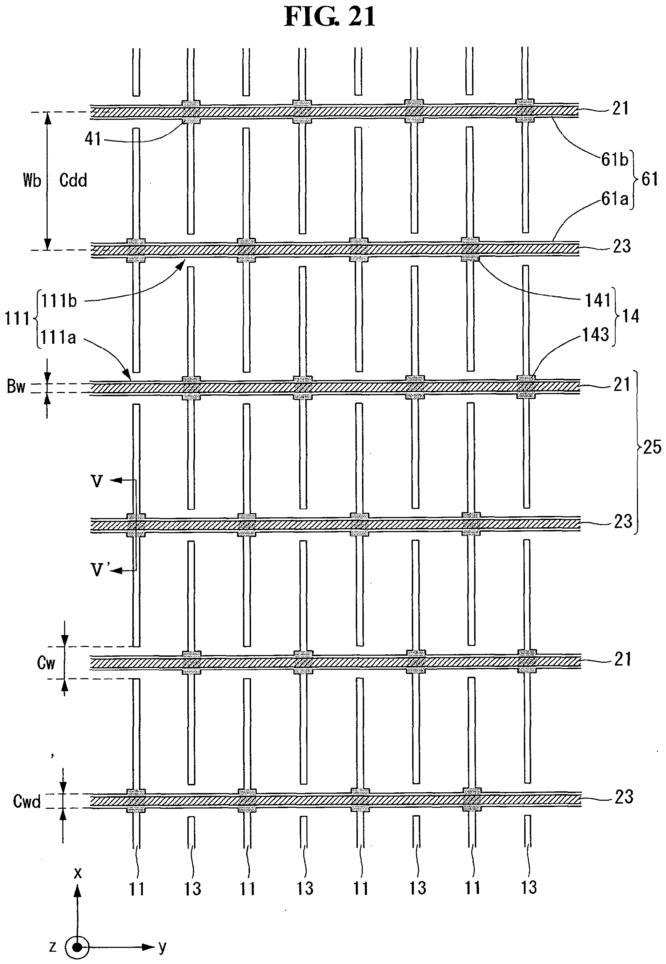

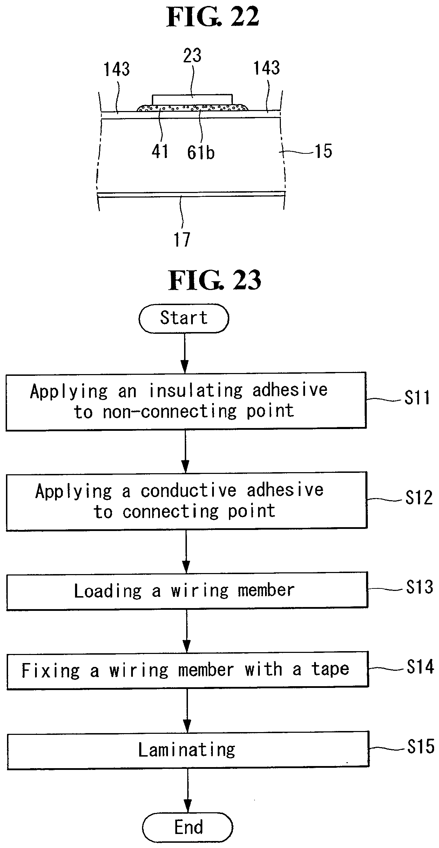

FIG. 21 shows a connection electrode for electrically connecting the pad 14, and FIG. 22 is a cross-sectional view taken along line V-V' of FIG. 21.

In the example of the invention, the first electrode 11 includes the first pad 141 and the first disconnection portion 111a, and the second electrode 13 includes the second pad 143 and the second disconnection portion 111b.

In the example of the invention, a connection electrode 61 extends in the horizontal direction (for example, y-axis direction in the drawing) and overlaps the wiring member 25. The connection electrode 61 may be formed along with the electrodes 11 and 13 in the same process as the electrodes 11 and 13 or may be separately formed in a process different from the electrodes 11 and 13. When the connection electrode 61 is formed in the same process as the electrodes 11 and 13, the connection electrode 61 and the electrodes 11 and 13 may be formed of the same material, and thus the number of manufacturing processes may be reduced. When the connection electrode 61 and the electrodes 11 and 13 are formed in different processes, the connection electrode 61 and the electrodes 11 and 13 may be formed of different materials. Hence, a selection width of the materials used in the connection electrode 61 and the electrodes 11 and 13 may widen.

In other words, when the connection electrode 61 and the electrodes 11 and 13 are formed in the same process, the connection electrode 61 and the electrodes 11 and 13 may be formed of the same material. When the connection electrode 61 and the electrodes 11 and 13 are formed in the different processes, the connection electrode 61 and the electrodes 11 and 13 may be formed of the different materials.

The connection electrode 61 includes a first connection electrode 61a and a second connection electrode 61b. The first connection electrode 61a is physically and electrically connected to the first pad 141 of the first electrode 11, which is adjacent to the second disconnection portion 111b across the second disconnection portion 111b provided in the second electrode 13. The second connection electrode 61b is physically and electrically connected to the second pad 143 of the second electrode 13, which is adjacent to the first disconnection portion 111a across the first disconnection portion 111a provided in the first electrode 11, in the same manner as the first connection electrode 61a.

The first connection electrode 61a and the second connection electrode 61b are separated from each other by a predetermined distance Cdd and are disposed in parallel with each other. The distance Cdd between the first connection electrode 61a and the second connection electrode 61b is substantially the same as a distance Wb between the first wiring member 21 and the second wiring member 23.

Because the wiring member 25 is positioned on the connection electrode 61, it is preferable, but not required, that a width Cwd of the connection electrode 61 is equal to or greater than a width Bw of the wiring member 25 and is less than the vertical width of the pad 14.

The second wiring member 23 is positioned on the first connection electrode 61a, and the first wiring member 21 is positioned on the second connection electrode 61b.

The conductive layer 41 is positioned between the connection electrode 61 and the wiring member 25 and makes the connection between the connection electrode 61 and the wiring member 25 easy. The conductive layer 41 may be selectively omitted. In this instance, the wiring member 25 is directly soldered to the connection electrode 61. Alternatively, a solder paste may connect the wiring member 25 to the connection electrode 61.

A method for manufacturing the solar cell module according to the example not forming part of the present invention is described below with reference to FIG. 23.

In step S11, an insulating adhesive for forming an insulating layer is applied to each non-connection portion. The insulating adhesive is a mixture of a curing agent containing liquid epoxy-based or silicon-based synthetic resin having viscosity as a main component, a filler, a reinforcing agent, etc. The insulating adhesive may be applied to the non-connection portion through a known method such as a screen printing method, an inkjet method, and a dispensing method.

The insulating adhesive may be applied to the non-connection portion in the island shape, so that the wiring member 25 is not connected to one of the first electrode 11 and the second electrode 13 as in the pattern shown in FIG. 8.

In conditions of a process temperature, a curing temperature of the insulating adhesive varies depending on the material forming the insulating adhesive. A melting temperature, that is required to melt the insulating adhesive after the insulating adhesive is cured, has to be higher than curing temperatures of a conductive adhesive and the wiring member 25. It is preferable, but not required, that the curing temperature of the insulating adhesive is higher than 210 °C and lower than 250 °C, and the melting temperature of the insulating adhesive is equal to or higher than 400 °C.

After the insulating adhesive is applied, the insulating adhesive is exposed at a temperature equal to or higher than its curing temperature and is cured. Hence, an insulating layer is formed.

The step S11 may be omitted in consideration of the configuration of the solar cell module. For example, because the solar cell module, in which the electrodes 11 and 13 include the disconnection portion, does not need the insulating layer 43, the step S11 may be omitted in the method for manufacturing the solar cell module.

In step S12, a conductive adhesive for forming the conductive layer is applied to each connection portion. The conductive adhesive is a mixture of a curing agent containing liquid epoxy-based or silicon-based synthetic resin having viscosity as a main component, a filler, a reinforcing agent, etc., and further includes conductive particles. The conductive particles may use a metal material of Ni, Al, Ag, Cu, Pb, Sn or a metal material having a chemical formula indicated by SnIn, SnBi, SnPb, SnCuAg, SnCu, or a mixture including at least two thereof. The conductive adhesive may use a solder paste. The solder paste is a paste including solder particles containing lead (Pb) or tin (Sn). When heat equal to or higher than a melting temperature is applied to the solder paste, the solder paste combines two basic materials while melting the solder particles existing in the solder paste.

The conductive adhesive may be applied to the connection portion through a known method, such as the screen printing method, the inkjet method, and the dispensing method, in the same manner as the insulating adhesive.

The conductive adhesive may be applied to the connection portion in the island shape, so that the wiring member 25 is connected to one of the first electrode 11 and the second electrode 13 as in the pattern shown in FIG. 8.

In conditions of a process temperature, a curing temperature of the conductive adhesive varies depending on the material forming the conductive adhesive in the same manner as the insulating adhesive. The curing temperature of the conductive adhesive has to be lower than the melting temperature of the insulating layer 43. A melting temperature of the conductive adhesive after curing the conductive adhesive has to be higher than the curing temperature of the wiring member 25.

Preferably, the curing temperature of the conductive adhesive may be substantially the same as a laminating temperature in step S15. When the curing temperature of the conductive adhesive is substantially the same as the laminating temperature in step S15, the conductive adhesive does not need to be cured immediately after the conductive adhesive is applied, because the conductive adhesive may be cured in step S15. Hence, the number of manufacturing processes may decrease. Further, because the number of times of the solar cell exposed at the high temperature decreases, the thermal deformation of the solar cell may decrease.

Furthermore, when the curing temperature of the insulating adhesive is substantially the same as the laminating temperature in step S15, the insulating adhesive does not need to be cured in step S11 and may be cured along with the conductive adhesive in step S15. Hence, the two curing processes (of the insulating adhesive and the conductive adhesive) may be omitted.

When the curing temperature of the conductive adhesive is different from the laminating temperature in step S15, the conductive adhesive is applied and then is exposed at the curing temperature to form the conductive layer.

Next, the first wiring member 21 and the second wiring member 23 are loaded in step S13. The first wiring member 21 and the second wiring member 23 are arranged in the form of connecting the two solar cells, which are adjacent to each other in the longitudinal direction, as shown in the example of FIG. 8. The first wiring member 21 and the second wiring member 23 are alternately disposed in the direction crossing the longitudinal direction.

Next, in step S14, the loaded first and second wiring members 21 and 23 are fixed using a tape so that they do not move. In step S14, the tape may use a liquid tape applying a liquid material and a solid tape, in which an adhesive is applied to a film. The liquid tape may be formed by applying the liquid material to the first wiring member 21 and the second wiring member 23 using a dispenser, irradiating ultraviolet rays (UV) onto the liquid material, and curing the liquid material. Alternatively, the liquid tape may be formed by applying and curing the liquid material using the method such as the screen printing method and the inkjet printing method. The liquid material may use an epoxy-based synthetic resin or a silicon-based synthetic resin.

The tape is attached in a direction crossing the wiring member 25, so as to easily fix the wiring member 25. The tape may use any type tape as long as the tape can fix the wiring member 25. For example, the tape may be attached to the entire back surface of the solar cell, on which the wiring member 25 is positioned, and may protect the solar cell from the moisture. Alternatively, if any one of the conductive adhesive and the insulating adhesive is not cured, the tape may be attached so that a portion of the conductive adhesive and the insulating adhesive is exposed.

The wiring member 25 may be temporarily fixed at the temperature, for example, 90 °C to 120 °C lower than the curing temperature before at least one of the conductive adhesive and the insulating adhesive is cured. In this instance, the step S14 may be omitted.

In step S15, an encapsulant and a transparent substrate are positioned on the modularized solar cell thus manufactured, and an encapsulant and a back sheet are positioned under the modularized solar cell. In such a position state of the modularized solar cell, they are thermally pressurized through a laminating device and are packaged. In this instance, a temperature of the thermal process is 145 °C to 165 °C. Because the electrodes are laminated in a state where all of the electrodes are fixed through the tape, the electrodes may be prevented from being out of alignment in the laminating process.

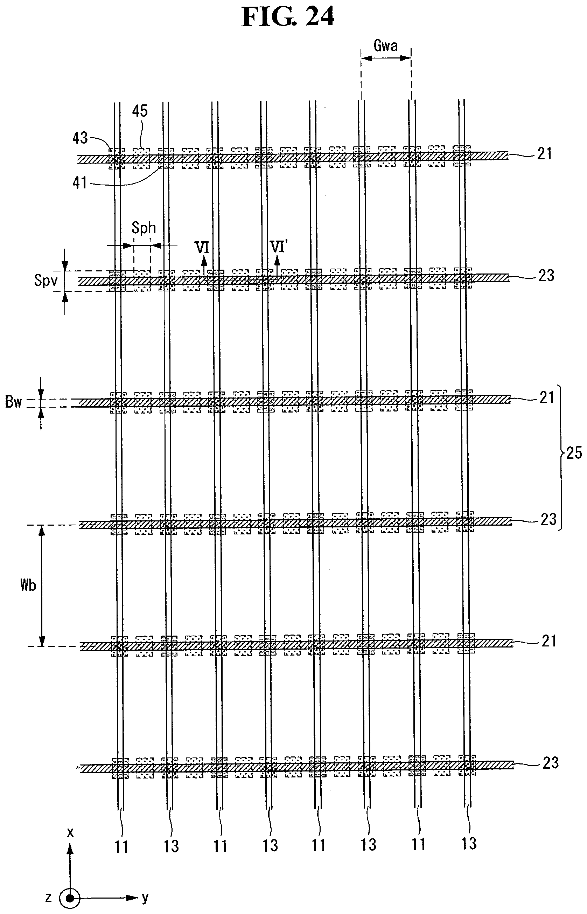

The examples of the invention, in which the solar cell is configured to further include a dispersion layer, are described below with reference to FIGS. 24 to 28. Only some of the following examples of the invention describe the solar cell including the dispersion layer. However, the configuration of the solar cell including the dispersion layer may be equally or similarly applied to the remaining examples of the invention.

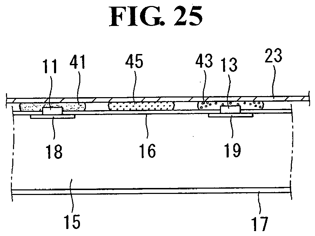

FIG. 24 shows a dispersion layer positioned between the conductive layer and the insulating layer, and FIG. 25 is a cross-sectional view taken along line VI-VI' of FIG. 24.

As shown in FIGS. 24 and 25, the first electrodes 11 and the second electrodes 13 are alternately arranged in the horizontal direction, and the first wiring members 21 and the second wiring members 23 are alternately arranged in the vertical direction.

The conductive layer 41 and the insulating layer 43 are positioned along the connection portion and the non-connection portion and selectively connect or insulate the wiring members 25 and the electrodes 11 and 13 at a crossing of the connection portion and the non-connection portion.

A dispersion layer 45 is positioned between the conductive layer 41 and the insulating layer 43 in the horizontal direction and is separated from the conductive layer 41 and the insulating layer 43. The dispersion layer 45 attaches the wiring member 25 to the substrate. It is preferable, but not required, that the dispersion layer 45 is positioned between the conductive layer 41 and the insulating layer 43. However, the dispersion layer 45 may be selectively formed, if necessary or desired.

Because the dispersion layer 45 is formed at crossings of the conductive layer 41 and the insulating layer 43 and between the crossings, a horizontal width Sph of the dispersion layer 45 is less than a distance Gwa between the first electrode 11 and the second electrode 13. Hence, the conductive layer 41 or the insulating layer 43 may be normally formed at the crossings.

In FIGS. 24 and 25, shown is the instance in which a vertical width Spv of the dispersion layer 45 is greater than the width Bw of the wiring member 25. When the vertical width Spv of the dispersion layer 45 is greater than the width Bw of the wiring member 25, the wiring member 25 may be stably attached to the substrate.

Preferably, the dispersion layer 45 may be formed of the same material as the conductive layer 41 or the insulating layer 43. Further, the dispersion layer 45 may be formed of the same material as the electrodes 11 and 13.

Considering the manufacturing process, it is preferable, but not required, that the dispersion layer 45 is formed along with the conductive layer 41 while forming the conductive layer 41. When the dispersion layer 45 is formed of the same material as the conductive layer 41, the dispersion layer 45 may be formed without adding a new process.

When the dispersion layer 45 is formed of the same material as the insulating layer 43, the dispersion layer 45 may be stably formed without the risk of the short circuit, which may be generated when the dispersion layer 45 is formed of the conductive material, because the dispersion layer 45 is positioned between the first electrode 11 and the second electrode 13 collecting carriers of different conductive types.

It is preferable, but not required, that an application area of each dispersion layer 45 thus formed is larger than the conductive layer 41 or the insulating layer 43. A stress transferred from the wiring member 25 is transferred to the crossing and breaks the physical connection between the electrode and the wiring member. When the application area of the dispersion layer 45 is larger than the conductive layer 41 or the insulating layer 43, the stress transferred to the dispersion layer 45 is greater than the stress transferred to the crossing. Thus, the stress transferred to the conductive layer 41 or the insulating layer 43 may be further reduced, compared to the related art.

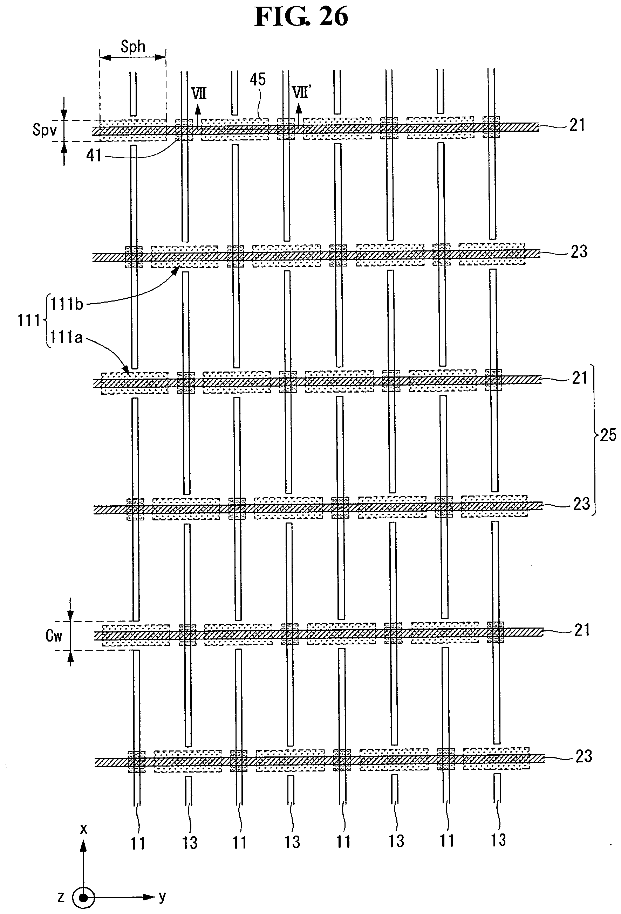

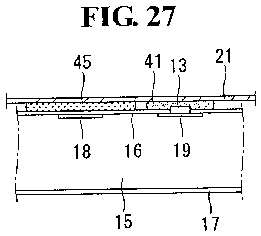

FIG. 26 shows the formation of the dispersion layer when the electrode includes the disconnection portion, and FIG. 27 is a cross-sectional view taken along line VII-VII' of FIG. 26.

As shown in FIGS. 26 and 27, the disconnection portion 111 is a portion, in which the electrodes 11 and 13 do not exist by a predetermined width Cw in the longitudinal direction of the electrodes 11 and 13.

The disconnection portion 111 is formed along non-connection portions and includes a first disconnection portion 111a and a second disconnection portion 111b. The first disconnection portion 111a is formed in the non-connection portions of the first electrode 11, and the second disconnection portion 111b is formed in the non-connection portions of the second electrode 13.

The conductive layer 41 is positioned along the connection portions and electrically connects the wiring member to the electrode.

In the example of the invention, the dispersion layer 45 extends in the non-connection portions, in which the disconnection portion 111 is formed, in the longitudinal direction of the wiring member 25 and attaches the wiring member 25 to the substrate.

Because the dispersion layer 45 is formed in the disconnection portion 111, the dispersion layer 45 is positioned between the conductive layers 41 in the longitudinal direction of the wiring member 25. Thus, the horizontal width Sph of the dispersion layer 45 is less than the distance between the first electrodes 11 or the distance between the second electrodes 13, which form the connection portion along with the wiring member 25. Further, when the vertical width Spv of the dispersion layer 45 is greater than the width of the wiring member 25, the wiring member 25 may be stably attached to the substrate.

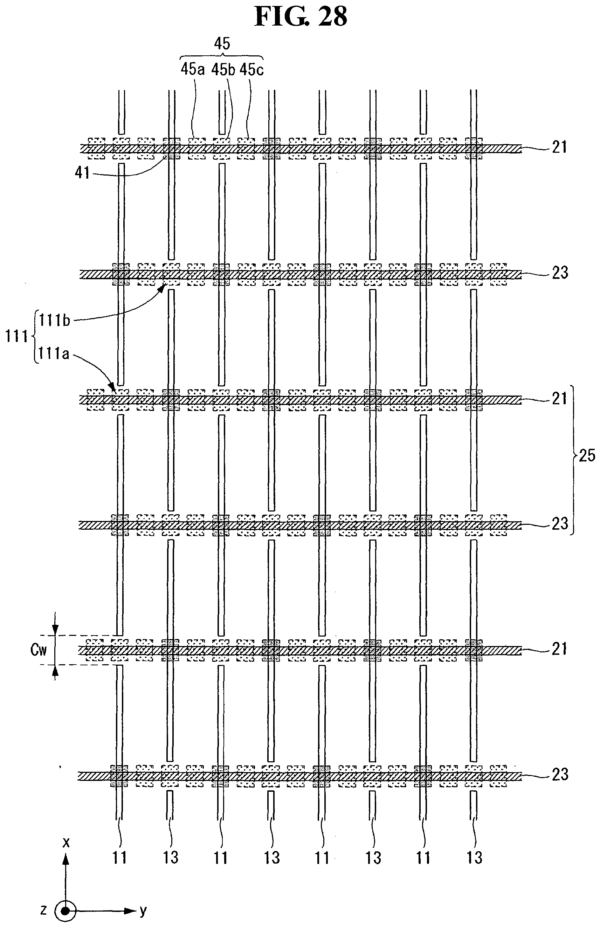

FIG. 28 shows an example where the dispersion layer is formed in the plural. In FIG. 28, the dispersion layer 45 is configured to include first to third dispersion layers 45a to 45c. In FIG. 28, shown is the instance in which the first to third dispersion layers 45a to 45c have the same size. The sizes of the first to third dispersion layers 45a to 45c may vary, if necessary or desired.

Hereinafter, a solar cell module including solar cells of a conventional structure, in which the first and second electrodes are formed on both the front surface and the back surface of the substrate, is described. There is a structural difference between the above-described solar cells and the conventional solar cells. However, the solar cells according to the example of the invention are the same in that the solar cell includes the pads having the different sizes. Therefore, the solar cells according to the example of the invention share the technical ideas with one another.

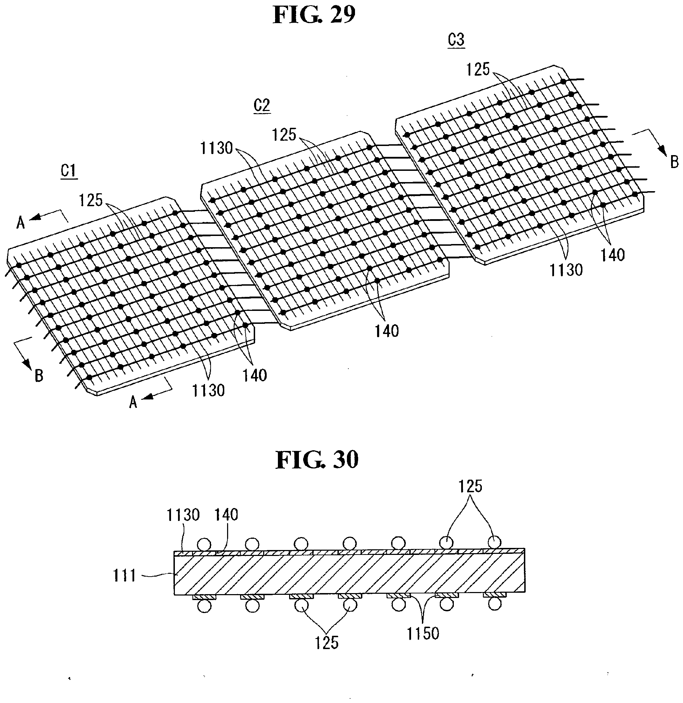

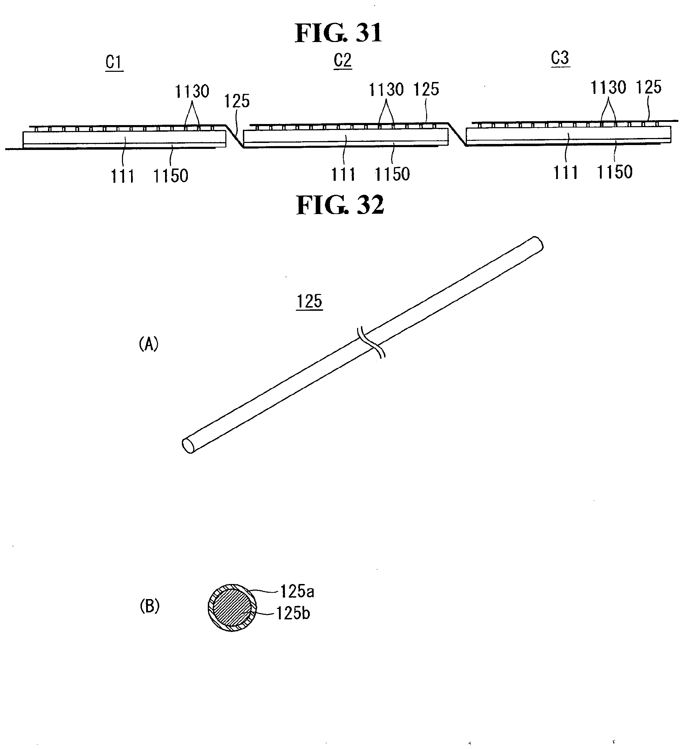

FIG. 29 is a prospective view of a solar cell module including solar cells of a conventional structure. FIG. 30 is a cross-sectional view taken along line A-A of FIG. 29. FIG. 31 is a cross-sectional view taken along line B-B of FIG. 29. FIG. 32 shows a wiring member.

As shown in FIGS. 29 to 32, the solar cell module according to the embodiment of the invention connects a plurality of solar cells, which are positioned adjacent to each other, using a plurality of wiring members 125 having each a thin thickness. The wiring member 125 is electrically connected to first electrodes 113 formed on a front surface of a first solar cell C1 of two adjacent solar cells and is electrically connected to second electrodes 115 formed on a back surface of a second solar cell C2 adjacent to the first solar cell C1.

The solar cell has a cube shape having a thin thickness. The solar cell of the cube shape has the size of approximately 156 mm long and 156 mm wide and a thickness of 150 µm to 200 µm.

The first electrodes 113 are formed on a front surface of a semiconductor substrate 111, on which light is incident, and are connected to the wiring member 125. The first electrodes 113 collect carriers of a conductive type opposite a conductive type of the semiconductor substrate 111. For example, if the semiconductor substrate 111 is a p-type semiconductor substrate, the first electrodes 113 may collect electrons.

The semiconductor substrate 111 forms a p-n junction and is an n-type or p-type semiconductor substrate containing impurities of a first conductive type.

The second electrodes 115 are formed on a back surface of the semiconductor substrate 111 in a direction crossing the first electrodes 113. The second electrodes 115 collect carriers of a conductive type opposite a conductive type of the first electrodes 113.

An emitter region and a back surface field region, each of which reduces a potential barrier, and a passivation layer preventing a recombination of carriers at the surface of the semiconductor substrate 111 exist between the semiconductor substrate 111 and the first electrodes 113, and between the semiconductor substrate 111 and the second electrodes 115. However, the above configuration was omitted in the drawings.

The two adjacent solar cells each having the above-described configuration are connected to each other using the plurality of wiring members 125. '

The number of wiring members 125 may be 6 to 30. As shown in (A) of FIG. 32, the wiring member 125 may have a wire shape having a circular cross section. (B) of FIG. 32 shows the circular cross section of the wiring member 125.

As shown in FIG. 32, the wiring member 125 has a structure, in which a coating layer 125a is coated on a core layer 125b with a thin thickness (for example, about 12 µm or less). The entire thickness of the wiring member 125 is 300 µm to 500 µm.

The core layer 125b is formed of a metal material with good conductivity, for example, Ni, Cu, Ag, and Al. The coating layer 125a is formed of Pb, Sn, or a metal material having a chemical formula indicated by SnIn, SnBi, SnPb, SnCuAg, and SnCu and includes a solder. Hence, the coating layer 125a may be physically and electrically connected to another metal through the soldering.

When the two adjacent solar cells are connected to each other using the wiring member 125, 10 to 15 wiring members 125 may be used when the size of the semiconductor substrate is 156 mm long and 156 mm wide. The number of wiring members 125 may vary depending on the size of the semiconductor substrate, a width, a thickness, a pitch of the electrodes, etc.

So far, the embodiment of the invention described the wiring member 125 having the wire shape of the circular cross section. However, the cross section of the wiring member 125 may have various shapes including a rectangle and an oval.

The wiring member 125 electrically connects the two adjacent first and second solar cells C1 and C2 by connecting one side of the wiring member 125 to the first electrode 1130 of the first solar cell C1 and connecting the other side of the wiring member 125 to the second electrode 1150 of the second solar cell C2. A preferable method for connecting the electrodes to the wiring member is the soldering method for melting and combining the basic material.

In the embodiment of the invention, at least a portion of the first electrodes 113 may include a plurality of first pads 140, which are positioned at crossings of the first electrodes 113 and the wiring members 125, and have a width w1 greater than a width of the first electrode 1130.

The first pad 140 increases an area of the crossing of the first electrode 1130 and the wiring member 125, and reduces a contact resistance when the first electrode 1130 is connected to the wiring member 125. Further, the first pad 140 increases a physical connection strength between the first electrode 1130 and the wiring member 125. In this instance, the width of the first electrode 1130 may increase, or another electrode layer may be additionally formed.

A size of at least one of the first pads 140 may be different from a size of the remaining first pads 140, so as to further improve the physical connection strength and the contact resistance between the wiring members 125 and the semiconductor substrate 111 while minimizing the bending of the wiring members 125 and the bending of the semiconductor substrate 111. A difference between the sizes of the first pads 140 means that the first pads 140 are different from each other in at least one of the width or the length. Thus, the first pads 140 may include at least two pads, which are different from each other in at least one of the width or the length. This is described below.

The number of first pads 140 may be equal to or greater than 6 and may be less than the number of first electrodes 113.

The width w1 of each first pad 140 may be greater than the width of the first electrode 1130 and may be less than 2.5 mm in consideration of a shading area, in which light is shaded by the first pad 140, the physical connection strength, and the contact resistance. Further, the length of each first pad 140 may be greater than the width of the first electrode 1130 and may be less than 30 mm.

As an example of the soldering method, the wiring members 125 are positioned on both the front surface and the back surface of each of the two adjacent solar cells and are positioned opposite the first electrodes 113 and the second electrodes 115 of each of the two adjacent solar cells. In such a state, the coating layers 125a of the wiring members 125 are heated for several seconds at a temperature equal to or higher than a melting temperature. As a result, while the coating layers 125a are melted and cooled, the wiring members 125 are attached to the first and second electrodes 113 and 115.

In an alternative example, the wiring members 125 may be attached to the electrodes using a conductive adhesive. The conductive adhesive is a material obtained by adding conductive particles formed of Ni, Al, Ag, Cu, Pb, Sn, SnIn, SnBi, SnPb, SnCuAg, and SnCu to an epoxy-based synthetic resin or a silicon-based synthetic resin. The conductive adhesive is a material cured when heat is applied to the conductive adhesive of a liquid state. Further, the wiring member 125 may be attached in a state of a solder paste. The solder paste is a paste including solder particles containing Pb or Sn, and melts and combines two basic materials while melting the solder particles existing in the solder paste when heat equal to or higher than a melting temperature is applied.

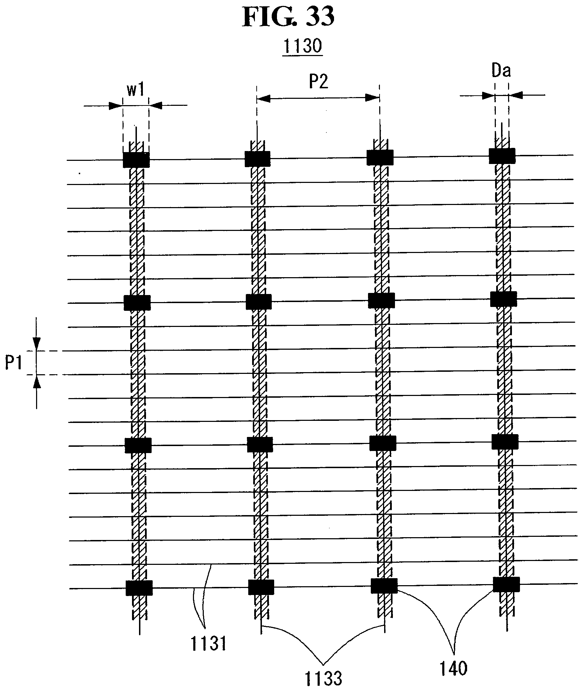

Various examples of the first electrode are described below with reference to FIGS. 33 to 39.

FIG. 33 shows a first example of the first electrode.

In FIG. 33, the first electrode 1130 includes a collection electrode 1131 and a connection electrode 1133.

The collection electrode 1131 has a predetermined width and extends in one direction. The collection electrodes 1131 are disposed in parallel with one another and form a stripe arrangement. The collection electrode 1131 has a width of 30 µm to 100 µm and a thickness of 15 µm to 30 µm. A pitch P1 between the collection electrodes 1131 is 1.2 mm to 2.2 mm.

The connection electrode 1133 has a predetermined width and extends in a direction crossing the collection electrode 1131. The connection electrodes 1133 electrically and physically connect the collection electrodes 1131.

A width of the connection electrode 1133 is substantially equal to or greater than a width of the collection electrode 1131 and is less than a width of the first pad 140. For example, the width of the connection electrode 1133 may be 75 µm to 120 µm. A thickness of the connection electrode 1133 is 15 µm to 30 µm. A pitch P2 between the connection electrodes 1133 may be 5 mm to 23 mm and may be less than 10 times the pitch P1 between the collection electrodes 1131.

Alternatively, the width of the connection electrode 1133 may be greater than the width of the collection electrode 1131 and may be equal to or less than a horizontal width w1 of the first pad 140.

The first pads 140 are selectively formed at crossings of the collection electrodes 1131 and the connection electrodes 1133.

The first pad 140 is configured so that the electrode and the wiring member 125 can be smoothly connected to each other by increasing the size of a crossing of the electrode and the wiring member 125, in the same manner as the above-described embodiment. It is preferable, but not required, that the first pads 140 are respectively formed at all of the crossings of the collection electrodes 1131 and the connection electrodes 1133. However, the first pads 140 may be selectively formed on odd-numbered lines or even-numbered lines, or may be selectively formed according to a predetermined rule. Namely, the first pads 140 may be respectively formed at all of the crossings or selectively formed at the crossings.

The number of first pads 140 is determined depending on the size, the thickness, and the pitch of the electrodes, and the like. FIG. 33 shows that the first pads 140 are selectively formed at all of the crossings of every six lines, as an example.

According to the result of an experiment, when the collection electrode 1131, the connection electrode 1133, and the first pad 140 were made within the scope of the present disclosure, the solar cell showed the most ideal efficiency. When any one of the collection electrode 1131, the connection electrode 1133, and the first pad 140 is out of the scope of the present disclosure, the solar cell did not show the desired efficiency.

The collection electrode 1131, the connection electrode 1133, and the first pad 140 may be simultaneously formed using the screen printing method. In this instance, the collection electrode 1131, the connection electrode 1133, and the first pad 140 may be formed of the same material, for example, silver (Ag). The components may be separately formed, if necessary or desired.

The wiring member 125 is positioned directly on the connection electrode 1133 and extends in a direction parallel to the connection electrode 1133. Thus, the wiring member 125 is positioned opposite the connection electrode 1133. A width Da of the wiring member 125 is 250 µm to 500 µm.

Because the wiring member 125 is soldered in a state where the wiring member 125 is positioned on the connection electrode 1133, the wiring member 125 is connected to the connection electrode 1133 as well as the first pad 140. Therefore, a contact resistance between the electrode and the wiring member may decrease, and the efficiency of the solar cell may increase. The connection strength of the wiring member may increase.

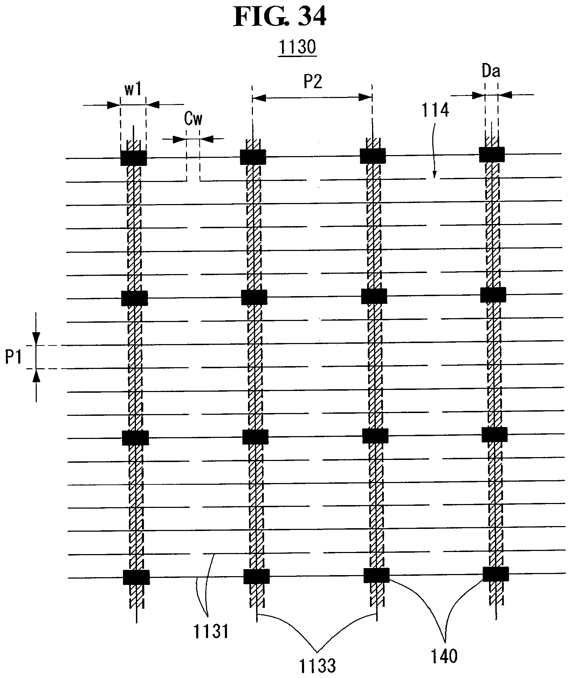

As shown in FIG. 34, which shows a second example of the first electrode, the collection electrode 1131 may further include a disconnection portion 114. The collection electrode 1131 does not exist by (or have) a predetermined width Cw of the disconnection portion 114 in an extension direction of the collection electrode 1131. When a pitch between the collection electrodes 1131 is 10 mm to 14 mm, the width Cw of the disconnection portion 114 may be 1.5 mm to 1.8 mm. Further, the width Cw of the disconnection portion 114 may be changed between 1.5 mm and 2.2 mm.

FIG. 34 shows that the disconnection portion 114 is formed every two lines, as an example. However, the second example of the first electrode may be changed. For example, the disconnection portion 114 may be formed on each line or every three lines, or may be randomly formed. In the second example of the first electrode, the disconnection portion 114 is formed between the connection electrodes 1133. However, the disconnection portion 114 may be formed at various positions.

In the second example of the first electrode, the connection electrodes 1133 connect the first pads 140, and the wiring member 125 is soldered on the connection electrode 1133. Therefore, a reduction in the efficiency of the solar cell resulting from the disconnection portion 114 is not generated. Further, because the collection electrode 1131 includes the disconnection portion 114, the manufacturing cost of the solar cell is reduced.

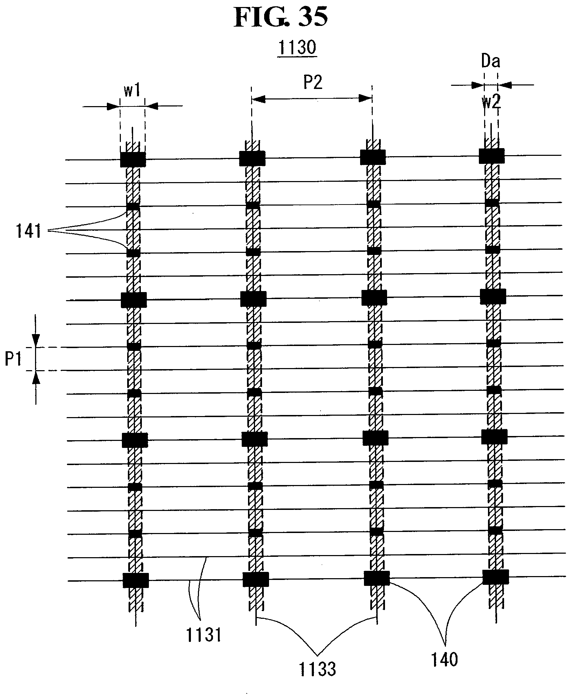

FIG. 35 shows a third example of the first electrode, in which an auxiliary pad is formed between the pads 140.

As shown in FIG. 35, in the solar cell module according to the embodiment of the invention, the size of at least one of the plurality of first pads 140 included in each solar cell may be different from the size of the remaining pads.

As shown in FIG. 35, for example, at least one pad may be an auxiliary pad 141 having a relatively small size. Further, the remaining pads may be pads 140 having a relatively larger size than the auxiliary pad 141.

Accordingly, the auxiliary pad 141 has a width or a length less than the pad 140. The auxiliary pad 141 is formed at a crossing positioned between the first pads 140 in the vertical direction and connects the wiring member 125 and the connection electrodes 1133.

The auxiliary pad 141 may be formed of the same material as the first pad 140. Alternatively, the auxiliary pad 141 may be formed of a conductive adhesive formed of an adhesive resin including conductive metal particles.

It is preferable, but not required, that a horizontal width w2 of the auxiliary pad 141 is equal to or less than the width Da of the wiring member 125.

The size of the auxiliary pad 141 is properly adjusted in consideration of various variables in the same manner as the first pad 140.

FIG. 35 shows that the auxiliary pad 141 is formed between the first pads 140 every two lines, as an example. The auxiliary pad 141 may be formed at various positions. For example, the auxiliary pad 141 may be formed on each line or at a position corresponding to a multiple of three.

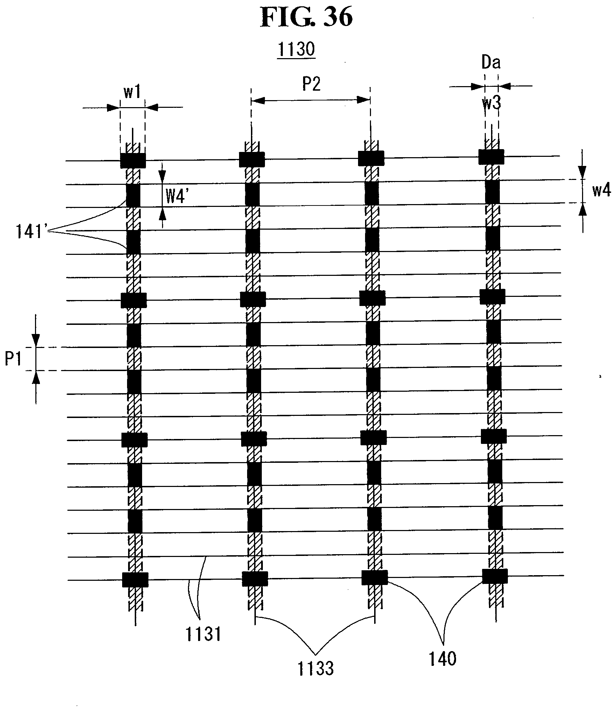

FIG. 36 shows another shape of the auxiliary pad as a fourth example of the first electrode not forming part but useful for understanding the present invention. The auxiliary pad 141 shown in FIG. 35 is substantially the same as an auxiliary pad 141' shown in FIG. 36, except that the auxiliary pad 141' shown in FIG. 35 is formed at the crossing, and the auxiliary pad 141' shown in FIG. 36 connects the collection electrodes 1131 of two adjacent lines.

A horizontal width w3 of the auxiliary pad 141' of FIG. 36 is less than the first pad 140, and a vertical width w4' of the auxiliary pad 141' is greater than the first pad 140. Thus, a contact area between the wiring member 125 and the first electrode 1130 may further increase. Hence, a contact resistance may decrease, and a connection strength may increase.

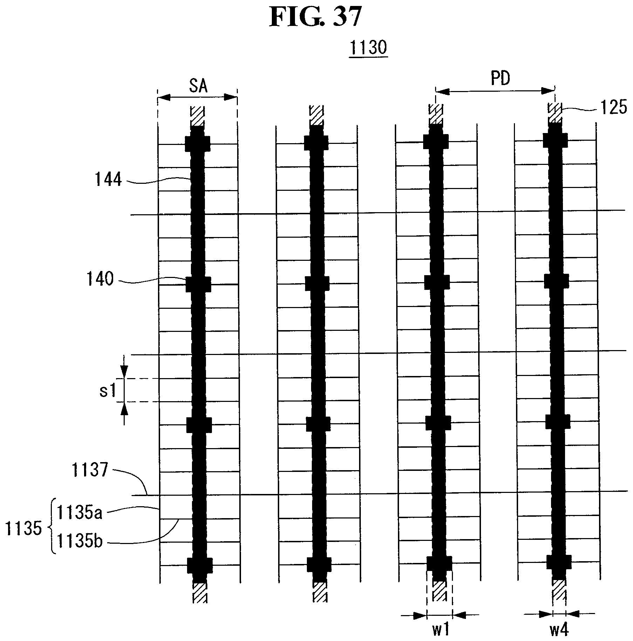

FIG. 37 shows a fifth example of the first electrode not forming part but useful for understanding the present invention.

In the fifth example of the first electrode, the first electrode 1130 includes a ladder electrode 1135 and a wiring electrode 1137.

The ladder electrode 1135 includes a pair of legs 1135a and a connector 1135b connecting the legs 1135a. Thus, the ladder electrodes 1135 form a ladder shape.

The legs 1135a are separated from each other by a predetermined distance SA and extend in the same direction as an extension direction of the wiring member 125. The distance SA between the legs 1135a is less than a pitch PD of the wiring member 125 and is greater than the width w1 of the first pad 140. Preferably, the distance SA between the legs 1135a is 0.3 to 0.7 of the pitch PD of the wiring member 125.

The connector 1135b connects the pair of legs 1135a in a direction crossing the legs 1135a. The connectors 1135b are separated from each other by a predetermined distance S1, and the width S1 of the connector 1135b is 1.3 mm to 1.9 mm.

The leg 1135a and the connector 1135b constituting the ladder electrode 1135 have a width of 30 µm to 120 µm similar to the width of the collection electrode or the connection electrode.

The wiring electrode 1137 electrically connects the two adjacent ladder electrodes 1135 in a direction crossing the ladder electrode 1135. The wiring electrode 1137 has a width of 30 µm to 120 µm in the same manner as the ladder electrode 1135.

The wiring member 125 is positioned along the middle of the ladder electrode 1135 and is connected to the ladder electrode 1135. The first pad 140 is selectively positioned at a position opposite the wiring member 125. An extension electrode 144 is positioned between the first pads 140 and connects the first pads 140.

Since the first pad 140 according to the fifth example of the first electrode is substantially the same as the first pad 140 according to the first example of the first electrode, a further description may be briefly made or may be entirely omitted.

A width w4 of the extension electrode 144 is equal to or less than a width w1 of the first pad 140, is equal to or greater than the width of the leg 1135a or the connector 1135b constituting the ladder electrode 1135, and is less than a distance SA between the legs 1135a. The extension electrode 144 is a portion opposite the wiring member 125 and is a portion connected to the wiring member 125 when the wiring member 125 is soldered to the first electrode 1130. Thus, when the extension electrode 144 is formed in an opposite portion of the wiring member 125 and the first electrode 1130, a connection area between the wiring member 125 and the first electrode 1130 increases. Hence, a connection strength therebetween may increase, and a contact resistance may decrease.

In the fifth example of the first electrode, the ladder electrode 1135, the wiring electrode 1137, the first pad 140, and the extension electrode 144 may be simultaneously formed through the screen printing method. In this instance, they may be made of the same metal material, for example, silver (Ag). Alternatively, they may be individually formed through different processes.

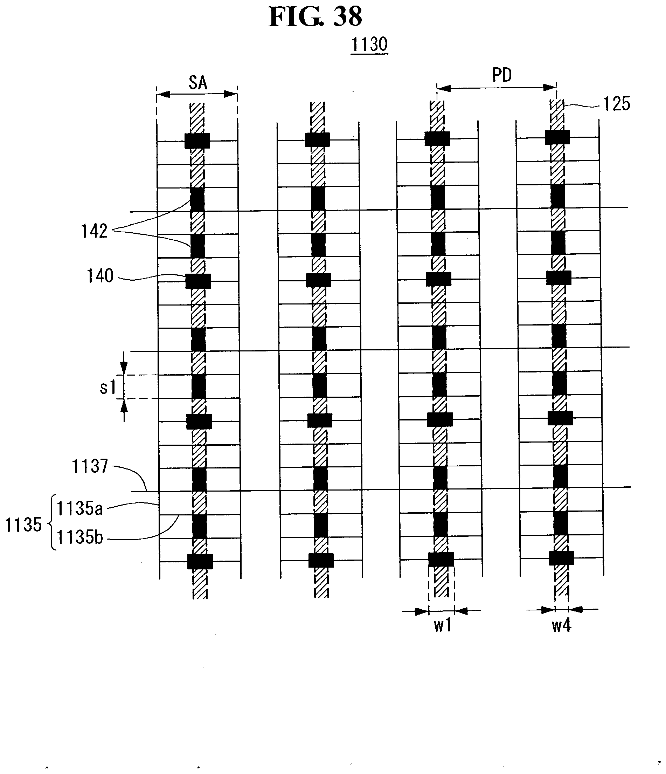

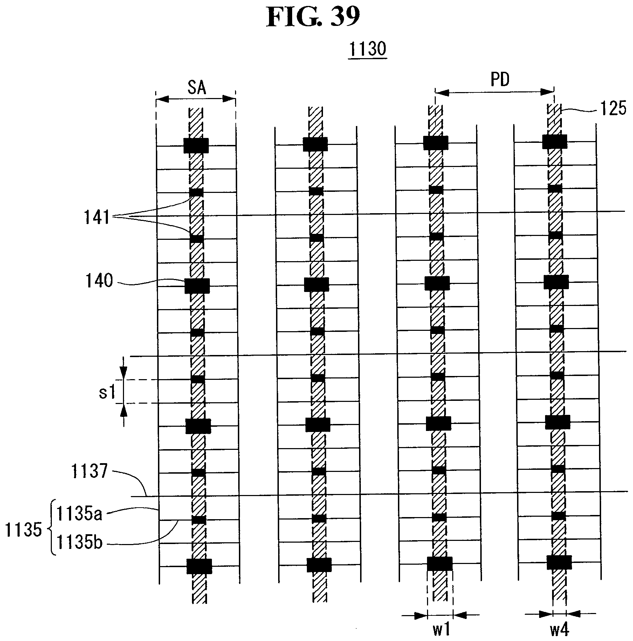

FIGS. 38 and 39 show that instead of the extension electrode 144, an auxiliary pad is formed between the first pads. The first electrode 1130 shown in FIGS. 38 and 39 is different from the first electrode 1130 shown in FIG. 37, in that instead of the extension electrode 144, the auxiliary pads 141 and 142 are positioned between the first pads 140 and connect the first pads 140.

In the same manner as the extension electrode 144, a contact area between the auxiliary pads 141 and 142 and the wiring member 125 may increase. Hence, a connection strength therebetween may increase, and a contact resistance may decrease. Further, because the auxiliary pads 141 and 142 occupy an area smaller than the extension electrode 144, the manufacturing cost may be reduced.

Since the auxiliary pads 141 and 142 were described above, a further description may be briefly made or may be entirely omitted.

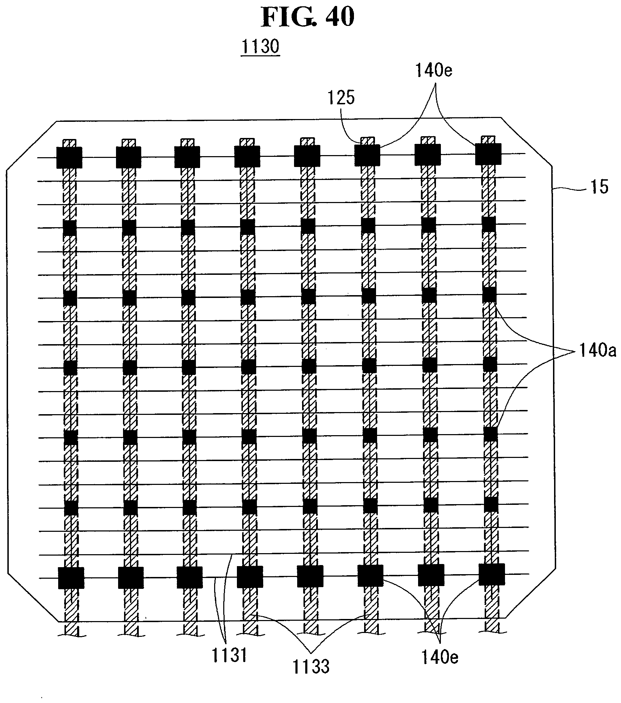

In FIG. 40 forming part of the present invention and showing the first electrode 1130, the first pad includes an extension pad 140e having a first size and an auxiliary pad 140a having a second size smaller than the first size.

In FIG. 40, the first electrode 1130 includes a collection electrode 1131 and a connection electrode 1133 in the same manner as the above-described examples.

The plurality of first pads 140 selectively includes the extension pads 140e and the auxiliary pads 140a at a position where the wiring members 125 pass through among crossings of the collection electrodes 1131 and the connection electrodes 1133.

In FIG. 40, the extension pad 140e has the first size, and the auxiliary pad 140a has the second size smaller than the first size. Namely, a width or a length of the extension pad 140e is greater than a width or a length of the auxiliary pad 140a. According to the present invention the length of the extension pad 140e is greater than a length of the auxiliary pad 140a.

The auxiliary pad 140a is positioned between a pair of the extension pads 140e in the longitudinal direction of the wiring member 125.

More specifically, the extension pad 140e is positioned closer to an end portion of the front surface of the semiconductor substrate 15 than to the auxiliary pad 140a along the longitudinal direction of the wiring member 125 in each of the plurality of solar cells.

For example, the extension pad 140e is positioned at the collection electrode 1131 positioned at the outermost side among the collection electrodes 1131 of the first electrode 1130 crossing the wiring member 125 along the longitudinal direction of the wiring member 125 on the front surface of the semiconductor substrate 15 of each solar cell.

Accordingly, the two extension pads 140e are respectively formed at the upper and lower sides (i.e., the both outermost sides) of the semiconductor substrate 15 along the longitudinal direction of the wiring member 125. The plurality of auxiliary pads 140a is formed between the extension pads 140e. However, the extension pads 140e are not limited thereto and are changed. For example, the plurality of extension pads 140e is formed at each of the upper and lower sides (i.e., the both outermost sides) of the semiconductor substrate 15 along the longitudinal direction of the wiring member 125.

The auxiliary pads 140a is respectively formed at all of the crossings between the extension pads 140e, or is intermittently positioned every two lines or every four lines. Because the number of auxiliary pads 140a is related to a connection strength of the wiring member 125 and the manufacturing cost, the number of auxiliary pads 140a is determined depending on a necessary connection strength and the manufacturing cost. Preferably, one auxiliary pad 140a is formed every one line to ten lines, and the number of auxiliary pads 140a is 6 to 48.

A width of the extension pad 140e is greater than the width of the wiring member 125 and isless than 2.5 mm. A length of the extension pad 140e is greater than the width of the first electrode 1130 and is less than 30 mm.

For example, the size of the extension pad 140e has the width (in a direction crossing the longitudinal direction of the wiring member) of 0.25 mm to 2.5 mm and the length (the extension direction of the wiring member) of 0.035 mm to 30 mm, preferably, 0.4 mm to 6 mm. The size of the auxiliary pad 140a has the width of 0.035 mm to 30 mm, preferably, 0.25 mm to 2.5 mm, and the length of 0.1 mm to 1mm.

More preferably, the width of the extension pad 140e is equal to the width of the auxiliary pad 140a, and the length of the extension pad 140e is three to ten times the length of the auxiliary pad 140a.

Accordingly, when the size of the extension pad 140e is larger than the size of the auxiliary pad 140a, the width of the extension pad 140e is greater than the width of the auxiliary pad 140a in a state where the length of the extension pad 140e is equal to the length of the auxiliary pad 140a. Alternatively, the length of the extension pad 140e is greater than the length of the auxiliary pad 140a in a state where the width of the extension pad 140e is equal to the width of the auxiliary pad 140a. Alternatively, both the width and the length of the extension pad 140e are greater than the width and the length of the auxiliary pad 140a.

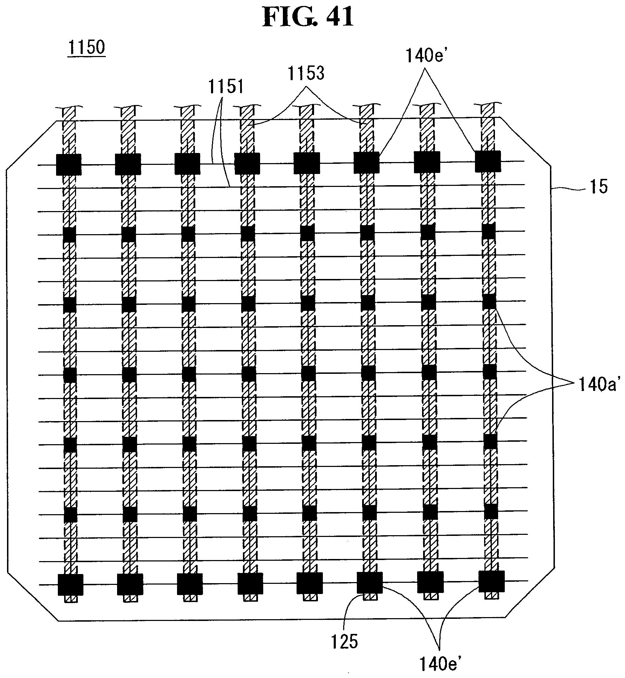

FIG. 41 forming part of the present invention shows that the second electrode 1150 includes an extension pad and an auxiliary pad.

As shown in FIG. 41, the second electrode 1150 includes a plurality of collection electrodes 1151 and connection electrodes 1153, in the same manner as the first electrode 1130. The connection electrodes 1153 are omitted, if necessary or desired.

The collection electrodes 1151 are positioned in parallel with one another and are formed in the direction crossing the longitudinal direction of the wiring member 125.

The collection electrode 1151 of the second electrode 1150 includes a plurality of second pads 140e' and 140a' formed at crossings of the wiring members 125 and the collection electrode 1151.

The number of second pads 140e' and 140a' is equal to or greater than six and is equal to or less than the number of collection electrodes 1151.

The second pads 140e' and 140a' include an auxiliary pad 140a' and an extension pad 140e' having each a different size. More specifically, the size of the extension pad 140e' is greater than the size of the auxiliary pad 140a'. Thus, a width or a length of the extension pad 140e' is greater than a width or a length of the auxiliary pad 140a'.

The extension pad 140e' is positioned closer to an end portion of the back surface of the semiconductor substrate 15 than to the auxiliary pad 140a' along the longitudinal direction of the wiring member 125 in each of the plurality of solar cells.

For example, the extension pad 140e' is positioned at the collection electrode 1151 positioned at the outermost side among the collection electrodes 1151 of the second electrode 1150 crossing the wiring member 125 along the longitudinal direction of the wiring member 125 on the back surface of the semiconductor substrate 15 of each solar cell.

Accordingly, the extension pads 140e' is respectively formed at the upper and lower sides (i.e., the both outermost sides) of the semiconductor substrate 15 along the longitudinal direction of the wiring member 125. The plurality of auxiliary pads 140a' is formed between the extension pads 140e'. However, the extension pads 140e' are not limited thereto and are changed. For example, the plurality of extension pads 140e' is formed at each of the upper and lower sides (i.e., the both outermost sides) of the semiconductor substrate 15 along the longitudinal direction of the wiring member 125.

When the second electrode 1150 includes the extension pads 140e' and the auxiliary pads 140a' in the same manner as the first electrode 1130, at least one of the width, the length, or the number of plurality of first pads 140e and 140a is different from at least one of the width, the length, or the number of plurality of second pads 140e' and 140a'.

For example, the number of first pads 140e and 140a formed on the front surface of the semiconductor substrate 15 is more than the number of second pads 140e' and 140a' formed on the back surface of the semiconductor substrate 15, and the size of each of the first pads 140e and 140a is smaller than the size of each of the second pads 140e' and 140a'. Further, the width of the collection electrode 1151 formed on the back surface of the semiconductor substrate 15 is greater than the width of the collection electrode 1131 formed on the front surface of the semiconductor substrate 15.

Further, the width of the extension pad 140e' is greater than the width of the wiring member 125 and is less than 2.5 mm. The length of the extension pad 140e' is greater than the width of the first electrode 1130 and is less than 30 mm.

For example, the width of the second pads 140e' and 140a' of the second electrode 1150 is 0.25 mm to 2.5 mm, the length of the second pads 140e' and 140a' is longer than the length of the first pads 140e and 140a. For example, the length of the extension pad 140e' is about 0.6 mm to 12 mm, preferably, about 5.5 mm to 7.5 mm, and the length of the auxiliary pad 140a' is about 0.2 mm to 3 mm, preferably, about 0.6 mm to 1.2 mm.

Because light is incident on the front surface of the semiconductor substrate 15, the shading area of the front surface of the semiconductor substrate 15 increases if the size of the first pads of the front surface of the semiconductor substrate 15 increases as in the second pads of the back surface of the semiconductor substrate 15. An amount of light incident on the front surface of the semiconductor substrate 15 decreases due to an increase in the shading area. Therefore, the embodiment of the invention reduces the size of the pads and increases the number of pads, so as to compensate for a reduction in the connection strength.

The widths of the extension pads and the auxiliary pads of the front surface and the back surface of the semiconductor substrate 15 are equal to or greater than the width of the wiring member and are equal to or less than five times it.

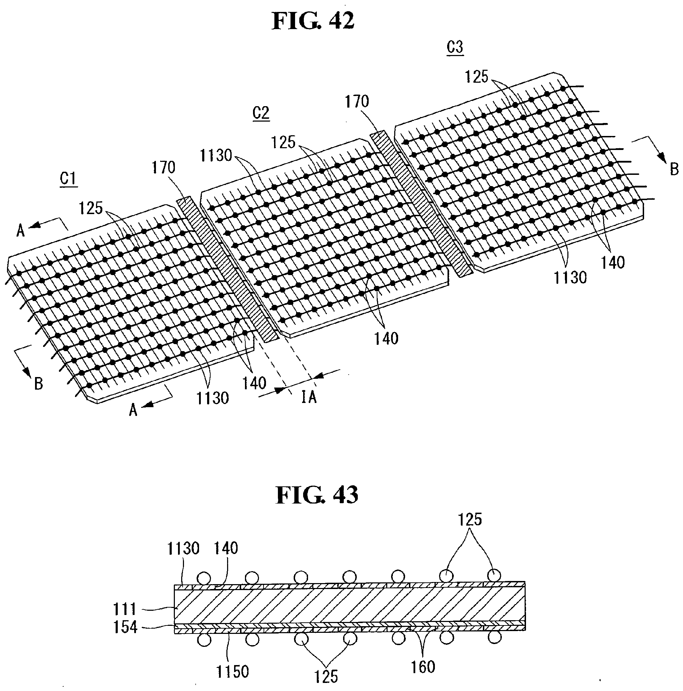

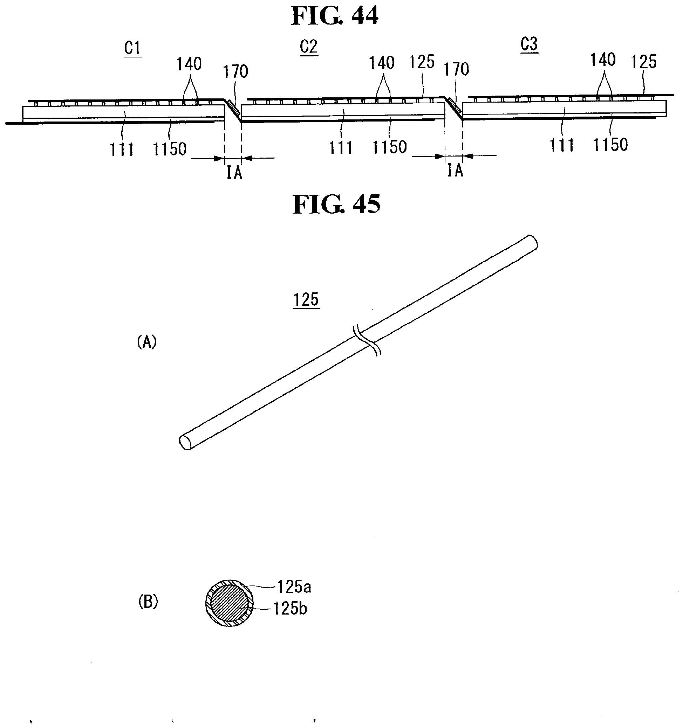

Hereinafter, the example of the invention, in which a solar cell module including solar cells of a conventional structure includes a reflector, is described with reference to FIGS. 42 to 45. FIG. 42 is a prospective view of the solar cell module. FIG. 43 is a cross-sectional view taken along line A-A of FIG. 42. FIG. 44 is a cross-sectional view taken along line B-B of FIG. 42. FIG. 45 shows a wiring member of the solar cell module shown in FIG. 42.

As shown in FIGS. 42 to 45, the solar cell module according to the example of the invention connects a plurality of solar cells, which are positioned adjacent to each other, using a plurality of wiring members 125 having each a thin thickness. The wiring member 125 is electrically connected to first electrodes 113 formed on a front surface of a first solar cell C1 of two adjacent solar cells and is electrically connected to second electrodes 115 formed on a back surface of a second solar cell C2 adjacent to the first solar cell C1.

The solar cell has a rectangular shape having a thin thickness and inclined edges or round edges. The solar cell has the size of approximately 156 mm long and 156 mm wide and a thickness of 150 µm to 200 µm.

The first electrodes 113 are formed on a front surface of a semiconductor substrate 111, on which light is incident, and are connected to the wiring member 125 through a first pad 140. The first electrodes 113 collect carriers of a conductive type opposite a conductive type of the semiconductor substrate 111. For example, if the semiconductor substrate 111 is a p-type semiconductor substrate, the first electrodes 113 may collect electrons.

The semiconductor substrate 111 forms a p-n junction and is an n-type or p-type semiconductor substrate containing impurities of a first conductive type.

The second electrodes 115 having a shape similar to the first electrodes 113 are formed on a back surface of the semiconductor substrate 111 and are connected to the wiring member 125 through a second pad 160. The second electrodes 115 collect carriers of a conductive type opposite a conductive type of the first electrodes 113.

The first electrode 1130 and the second electrode 1150 are described in detail below.

A back surface field region 154 is positioned between the semiconductor substrate 111 and the second electrode 1150. The back surface field region 154 is a region, which is more heavily doped than the semiconductor substrate 111 with impurities of the same conductive type as the semiconductor substrate 111, and is locally formed at a location corresponding to the second electrode 1150.

The back surface field region 154 of the same conductive type as the semiconductor substrate 111 may be of the n-type if the semiconductor substrate 111 is of the n-type. In this instance, the back surface field region 154 may be formed by injecting phosphorus (P) as an example of the impurities into the back surface of the semiconductor substrate 111. Preferably, the back surface field region 154 may be locally formed by implanting impurities into the back surface of the semiconductor substrate 111 through an ion implantation method.

A potential barrier is formed by a difference between impurity concentrations of the semiconductor substrate 111 and the back surface field region 154 and prevents or reduces carriers of the same conductive type as the semiconductor substrate 111 from moving to the back surface of the semiconductor substrate 111. Hence, the back surface field region 154 may prevent a recombination and/or a disappearance of carriers of different conductive types at and around the surface of the semiconductor substrate 111.

In the example of the invention, the back surface field region 154 is not formed at the entire back surface of the semiconductor substrate 111 and is formed at some of electrodes. However, the back surface field region 154 may be formed at the entire back surface of the semiconductor substrate 11.

The solar cells having the above-described configuration are connected to each other through the wiring member 125.

As shown in (A) of FIG. 45, the wiring member 125 may have a wire shape having a circular cross section. (B) of FIG. 45 shows a cross section of the wiring member 125.

As shown in FIG. 45, the wiring member 125 has a structure, in which a coating layer 125a is coated on a core layer 125b with a thin thickness (for example, about 12 µm or less). The entire thickness of the wiring member 125 is 250 µm to 550 µm.

The core layer 125b is formed of a metal material with good conductivity, for example, Ni, Cu, Ag, and Al. The coating layer 125a is formed of Pb, Sn, or a metal material having a chemical formula indicated by SnIn, SnBi, SnPb, SnCuAg, and SnCu and includes a solder. Thus, the coating layer 125a may be soldered.

When the two adjacent solar cells are connected to each other using the wiring member 125, 10 to 15 wiring members 125 may be used when the size of the semiconductor substrate is 156 mm long and 156 mm wide. The number of wiring members 125 may vary depending on the size of the semiconductor substrate, a width, a thickness, a pitch of the electrodes, etc.

So far, the example of the invention described the wiring member 125 having the wire shape of the circular cross section. However, the cross section of the wiring member 125 may have various shapes including a rectangle and an oval.

The wiring member 125 electrically connects the two adjacent first and second solar cells C1 and C2 by connecting one side of the wiring member 125 to the first electrode 1130 of the first solar cell C1 through the first pad 140 and connecting the other side of the wiring member 125 to the second electrode 1150 of the second solar cell C2 through the second pad 160. A preferable method for connecting the electrodes to the wiring member uses the soldering for melting and combining the material or a conductive adhesive, in which conductive particles are included in a synthetic resin having the adhesion.

In the example of the invention, a first pad 140 and a second pad 160 are positioned at a crossing of the first electrode 1130 and the wiring member 125 and at a crossing of the second electrode 1150 and the wiring member 125. The first and second pads 140 and 160 increase an area of the crossing of the first electrode 1130 and the wiring member 125 and an area of the crossing of the second electrode 1150 and the wiring member 125. Hence, when the wiring member 125 is connected to the first electrode 1130 and the second electrode 1150, the first and second pads 140 and 160 reduce a contact resistance and increase a connection strength between the electrodes 113 and 115 and the wiring member 125.

As an example of the soldering method, the wiring members 125 are positioned on both the front surface and the back surface of each of the two adjacent solar cells and are positioned opposite the first electrodes 113 and the second electrodes 115 of each of the two adjacent solar cells. In such a state, the coating layers 125a of the wiring members 125 are heated for several seconds at a temperature equal to or higher than a melting temperature. As a result, while the coating layers 125a are melted and cooled, the wiring members 125 are attached to the first and second electrodes 113 and 115.

In the example of the invention, a reflector 170 is positioned between the adjacent solar cells. The adjacent solar cells are separated from each other by a predetermined distance in the longitudinal direction of the wiring member 125, and an interspace IA exists between the adjacent solar cells. The reflector 170 is positioned in the interspace IA and scatters light incident on the interspace IA. Hence, the reflector 170 causes the light to be incident on the adjacent solar cell.

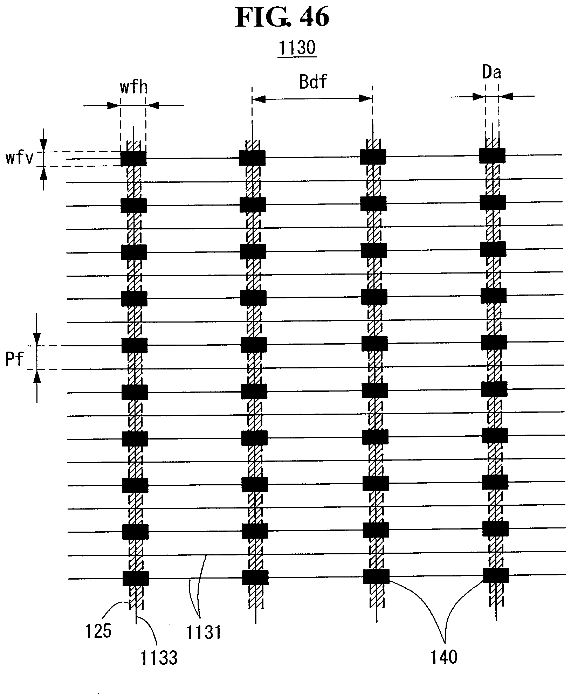

The first electrode 1130 of the solar cell module having the above-described configuration is described in detail below with reference to FIG. 46.

As shown in FIG. 46, the first electrode 1130 includes a collection electrode 1131 and a connection electrode 1133.

The collection electrode 1131 has a predetermined width and extends in one direction, for example, a direction crossing the longitudinal direction of the wiring member 125. The collection electrodes 1131 are disposed in parallel with one another and form a stripe arrangement. The collection electrode 1131 has a width of 35 µm to 100 µm, and a pitch Pf between the collection electrodes 1131 is 1.2 mm to 2.2 mm. Other values may be used for the collection electrode 1131. For example, the width and the pitch of the collection electrodes 1131 may be adjusted depending on various variables.

The connection electrode 1133 has a predetermined width and extends in a direction crossing the collection electrode 1131, namely, the same direction as the longitudinal direction of the wiring member 125. The connection electrodes 1133 electrically and physically connect the collection electrodes 1131.

A width of the connection electrode 1133 is substantially equal to or greater than a width of the collection electrode 1131 and is less than a width of the first pad 140. For example, the width of the connection electrode 1133 may be 30 µm to 120 µm. A pitch Bdf between the connection electrodes 1133 may be 5 mm to 23 mm and may be less than 10 times the pitch Pf between the collection electrodes 1131.

Alternatively, the width of the connection electrode 1133 may be greater than the width of the collection electrode 1131 and may be equal to or less than a horizontal width wfh of the first pad 140.

Because the connection electrode 1133 having the above-described configuration is not necessarily indispensable, the first electrode 1130 may include only the collection electrodes 1131 without the connection electrode 1133. If the connection electrode 1133 is omitted, an incident area of light may increase, and the manufacturing cost may be reduced.

The first pads 140 are selectively formed at crossings of the collection electrodes 1131 and the connection electrodes 1133. A vertical width wfv of the first pad 140 is greater than the width of the collection electrode 1131 and is less than 30 mm. A horizontal width wfh of the first pad 140 is greater than the width of the connection electrode 1133 and is less than 2.5 mm. For example, the horizontal width wfh of the first pad 140 may be 0.25 mm to 2.5 mm.

It is preferable, but not required, that the first pads 140 are respectively formed at all of the crossings of the collection electrodes 1131 and the connection electrodes 1133. However, the first pads 140 may be formed every two lines of the collection electrodes 1131 based on one connection electrode 1133 in consideration of the manufacturing cost, the efficiency, etc. FIG. 46 shows that the first pads 140 are formed at the crossings every 2*n lines of the collection electrodes 1131 in a longitudinal direction of the connection electrode 1133, where n is a natural number.

Accordingly, when the 12 connection electrodes 1133 and the 100 collection electrodes 1131 are formed, the total number of first pads 140 is 50^{∗}12.

The collection electrode 1131, the connection electrode 1133, and the first pad 140 may be simultaneously formed using the screen printing method. In this instance, the collection electrode 1131, the connection electrode 1133, and the first pad 140 may be formed of the same material, for example, silver (Ag). The components may be separately formed, if necessary or desired.

The wiring member 125 is positioned directly on the connection electrode 1133 and extends in a direction parallel to the connection electrode 1133. Thus, the wiring member 125 is positioned opposite the connection electrode 1133. A width Da of the wiring member 125 is 250 µm to 500 µm and is less than the horizontal width wfh of the first pad 140.

Because the wiring member 125 is soldered in a state where the wiring member 125 is positioned on the connection electrode 1133, the wiring member 125 is connected to the connection electrode 1133 as well as the first pad 140. Therefore, a contact resistance between the electrode and the wiring member may decrease, and the efficiency of the solar cell may increase. The connection strength of the wiring member may increase.

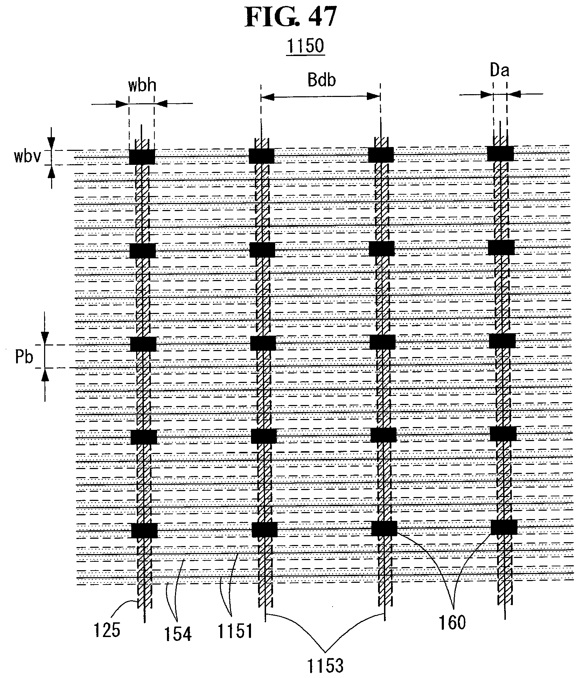

The second electrode 1150 is described in detail below with reference to FIG. 47.

As shown in FIG. 47, the second electrode 1150 includes a collection electrode 1151 and a connection electrode 1153 in the same manner as the first electrode 1130. In the following description, the collection electrode 1131 and the connection electrode 1133 of the first electrode 1130 are respectively referred to as the front collection electrode 1131 and the front connection electrode 1133, and the collection electrode 1151 and the connection electrode 1153 of the second electrode 1150 are respectively referred to as the back collection electrode 1151 and the back connection electrode 1153, so that the first and second electrodes 113 and 115 are not confused with each other.

The back collection electrode 1151 has a predetermined width and extends in one direction, for example, a direction crossing the longitudinal direction of the wiring member 125, thereby having a band shape. The back collection electrodes 1151 are disposed in parallel with one another and form a stripe arrangement.

The back collection electrode 1151 has a width of 35 µm to 120 µm, and a pitch Pb between the back collection electrodes 1151 is 1.2 mm to 2.2 mm in the same manner as the front collection electrode 1131. Preferably, the width of the back collection electrode 1151 may be greater than the width of the front collection electrode 1131, or the pitch Pb of the back collection electrode 1151 may be less than the pitch of the front collection electrode 1131.

As described above, the back collection electrode 1151 may be configured to be thicker than the front collection electrode 1131.

A serial resistance of the front surface of the semiconductor substrate is about 120 to 140 Ω/sq, and a serial resistance of the back surface of the semiconductor substrate is about 20 to 40 Q/sq and is less than the serial resistance of the front surface of the semiconductor substrate. Because of this, the number of pads formed on the front surface of the semiconductor substrate is more than the number of pads formed on the back surface of the semiconductor substrate, so as to increase a contact area between the front collection electrode 1131 and the wiring member 125. As a result, the pitch of the front collection electrode 1131 is greater than the pitch Pb of the back collection electrode 1151, and the number of back collection electrodes 1151 may be more than the number of front collection electrodes 1131.

FIG. 47 shows that the width of the front collection electrode 1131 is equal to the width of the back collection electrode 1151, as an example.

The back connection electrode 1153 has a predetermined width and extends in a direction crossing the back collection electrode 1151, namely, the same direction as the longitudinal direction of the wiring member 125. The back connection electrodes 1153 electrically and physically connect the back collection electrodes 1151.

The back connection electrode 1153 may have a width of 35 µm to 120 µm in the same manner as the back collection electrode 1151, and a pitch Bdb between the back connection electrodes 1153 may be 9 mm to 13 mm.

Alternatively, the width of the back connection electrode 1153 may be greater than the width of the back collection electrode 1151 and may be equal to or less than a horizontal width wbh of the second pad 160.

Because the back connection electrode 1153 having the above-described configuration is not necessarily indispensable, the second electrode 1150 may include only the back collection electrodes 1151 without the back connection electrode 1153. If the back connection electrode 1153 is omitted, an incident area of light may increase, and the manufacturing cost may be reduced.

The second pads 160 are selectively formed at crossings of the back collection electrodes 1151 and the back connection electrodes 1153, and thus the second electrode 1150 may be connected to the wiring member 125 through the second pads 160. In the example of the invention, the size of the second pad 160 is larger than the size of the first pad 140. For example, a width of the second pad 160 may be 0.25 mm to 2.5 mm, and a length of the second pad 160 may be 0.1 mm to 12 mm.

In the example of the invention, the number of second pads 160 is less than the number of first pads 140. FIGS. 46 and 47 show that the number of second pads 160 is one half of the number of first pads 140, as an example. The example of the invention described that both the size and the number of the first pads 140 are different from the size and the number of the second pads 160, as an example. However, the size of the first pads 140 may be different from the size of the second pads 160 in a state where the number of first pads 140 is the same as the number of second pads 160. Alternatively, the number of first pads 140 may be different from the number of second pads 160 in a state where the size of the first pads 140 is the same as the size of the second pads 160.

As shown in FIG. 47, the back surface field regions 154 are locally formed correspondingly to the back collection electrodes 1151 of the second electrode 1150. The back surface field region 154 is a region, which is more heavily doped than the semiconductor substrate 111 with impurities of the same conductive type as the semiconductor substrate 111. For example, if the impurity concentration of the semiconductor substrate 111 is 1*1016 atoms/cm3, the impurity concentration of the back surface field region 154 may be 2*1020 atoms/cm3.

In the example of the invention, because the back surface field regions 154 are locally formed correspondingly to the back collection electrodes 1151, the back surface field regions 154 are separated from one another by a predetermined distance in the same manner as the back collection electrodes 1151. Thus, the back surface field regions 154 entirely have a stripe arrangement.

As described above, the back collection electrodes 1151 are formed on the back surface of the semiconductor substrate 111 using the back surface field region 154, which is a heavily doped region, as an interface. Thus, a serial resistance of the back surface of the semiconductor substrate 111 is 20 to 40 Q/sq, and a serial resistance of the front surface of the semiconductor substrate is about 120 to 140 Q/sq and is about three times larger than the serial resistance of the back surface.

This indicates that the contact resistance between the electrode and the wiring member 125 at the front surface of the semiconductor substrate is much greater than the contact resistance between the electrode and the wiring member 125 at the back surface of the semiconductor substrate. According to the result of an experiment conducted by the present inventor, even when the number of second pads 160 was reduced to one half of the number of first pads 140, there was no influence on the efficiency of the solar cell. However, when the number of second pads 160 was less than one half of the number of first pads 140, the efficiency of the solar cell was greatly reduced.

Accordingly, the example of the invention can maintain the efficiency of the solar cell while efficiently reducing the manufacturing cost by further reducing the number of second pads 160 than the number of first pads 140.

The back collection electrode 1151, the back connection electrode 1153, and the second pad 160 may be simultaneously formed using the screen printing method. In this instance, the back collection electrode 1151, the back connection electrode 1153, and the second pad 160 may be formed of the same material, for example, silver (Ag). The components may be separately formed, if necessary or desired.

The wiring member 125 is positioned directly on the back connection electrode 1153 and extends in a direction parallel to the back connection electrode 1153. The pitch of the wiring member 125 is substantially equal to a pitch Bdb of the back connection electrode 1153.

Because the wiring member 125 is soldered in a state where the wiring member 125 is positioned on the back connection electrode 1153, the wiring member 125 is connected to the back connection electrode 1153 as well as the second pad 160 even when the number of second pads 160 is relatively less than the number of first pads 140. Therefore, the contact resistance between the electrode and the wiring member may decrease, and the connection strength of the wiring member may increase.

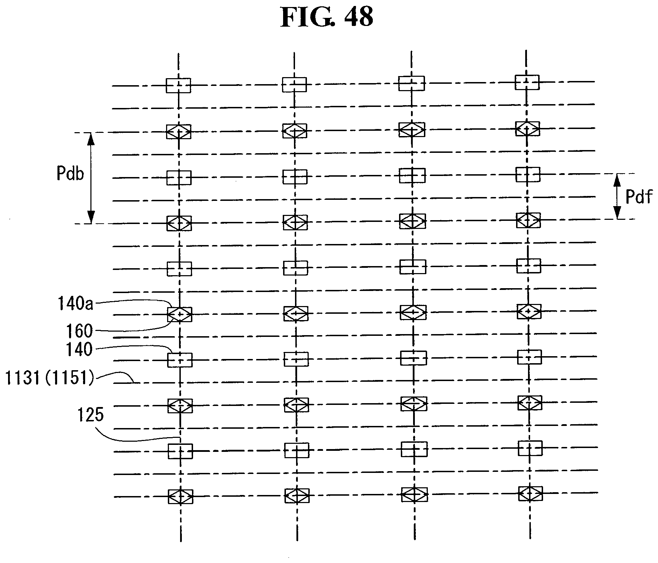

As described above, because the number of second pads 160 is less than the number of first pads 140, the first and second pads 140 and 160 may be variously arranged correspondingly to the first and second electrodes 113 and 115. This is described in detail below with reference to FIGS. 48 to 51.

FIGS. 48 to 51 briefly show only components which will be described in detail. In FIGS. 48 to 51, the one-dot chain line indicates the front collection electrode 1131, the dotted line indicates the back collection electrode 1151, and the two-dot chain line indicates the wiring member 125. It is assumed that the wiring members 125 are positioned on the same line at the front surface and the back surface of the semiconductor substrate, and the first and second pads 140 and 160 have the same size.

FIG. 48 shows that the front collection electrode 1131 and the back collection electrode 1151 have the same pitch and are positioned on the same line, as an example.

The first pads 140 are formed at a position corresponding to a multiple of two, and thus one crossing not having the first pad 140 exists in the longitudinal direction of the wiring member 125. The second pads 160 are formed at a position corresponding to a multiple of four, and thus three crossings not having the second pad 160 exist in the longitudinal direction of the wiring member 125. Thus, a pitch Pdf between the first pads 140 is less than a pitch Pdb between the second pads 160.

In the example of the invention, the second pads 160 are formed at the position corresponding to a multiple of four, and the first pads 140 are formed at the position corresponding to a multiple of two. Therefore, when the first pad 140 and the second pad 160 overlap each other, all of the second pads 160 overlap the first pads 140, and one first pad 140 is positioned between the second pads 160.

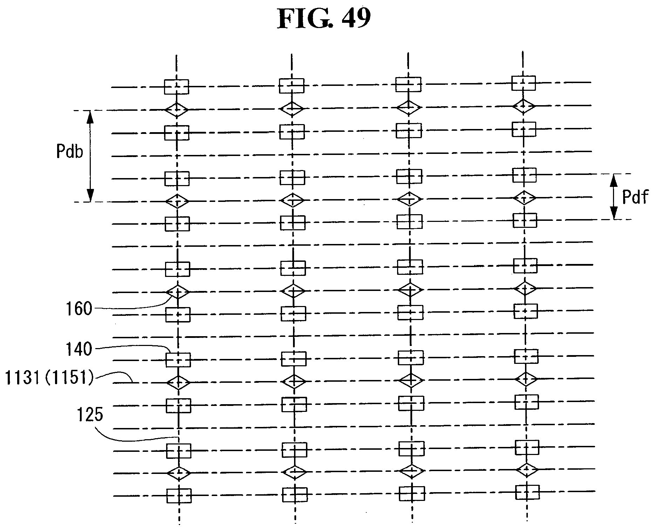

In FIG. 49, the front collection electrode 1131 and the back collection electrode 1151 are positioned on the same line in the same manner as FIG. 48. However, the second pad 160 does not overlap the first pad 140 and is positioned between the first pads 140. In this instance, because the first pads 140 are formed at the position corresponding to a multiple of two and the second pads 160 are formed at the position corresponding to a multiple of four, all of the second pads 160 do not overlap the first pads 140.

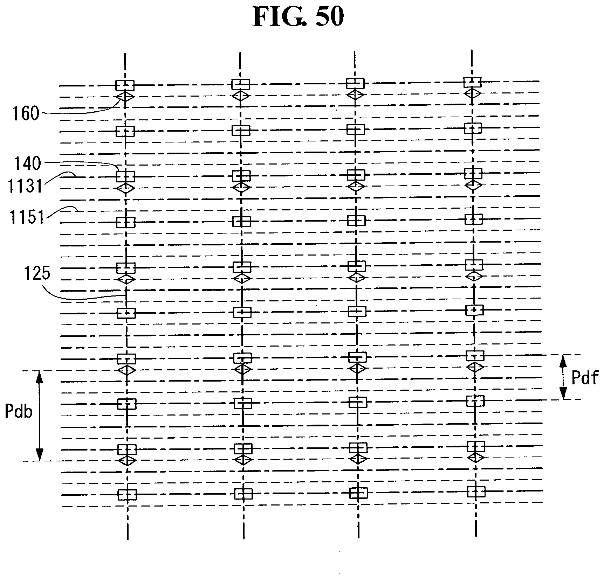

FIG. 50 shows that the front collection electrode 1131 and the back collection electrode 1151 have the same pitch and are not positioned on the same line, as an example.

In this instance, the front collection electrode 1131 and the back collection electrode 1151 are not positioned on the same line in the longitudinal direction of the wiring member 125 and are alternately positioned. Because the first pads 140 are formed at the position corresponding to a multiple of two and the second pads 160 are formed at the position corresponding to a multiple of four, the first pad 140 and the second pad 160 do not overlap.

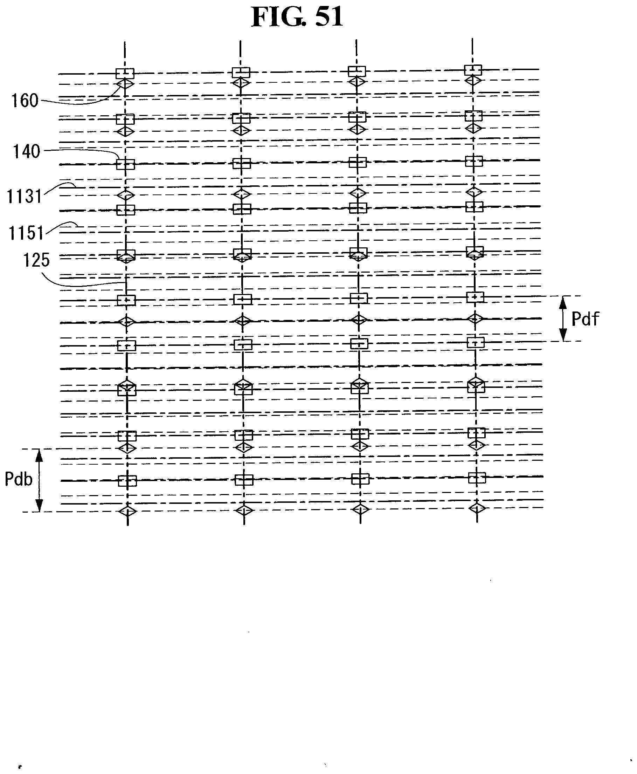

FIG. 51 shows that the pitch of the front collection electrode 1131 is greater than the pitch of the back collection electrode 1151, as an example. In this instance, because the pitch of the front collection electrode 1131 is greater than the pitch of the back collection electrode 1151, the front collection electrode 1131 and the back collection electrode 1151 may be positioned on the same line, may be positioned adjacent to each other, or may be far away from each other. In other words, the front collection electrode 1131 and the back collection electrode 1151 may be variously positioned.

Accordingly, the second pad 160 may be positioned at a position overlapping the first pad 140, may be positioned at a position partially overlapping the first pad 140, or may be positioned at another position.

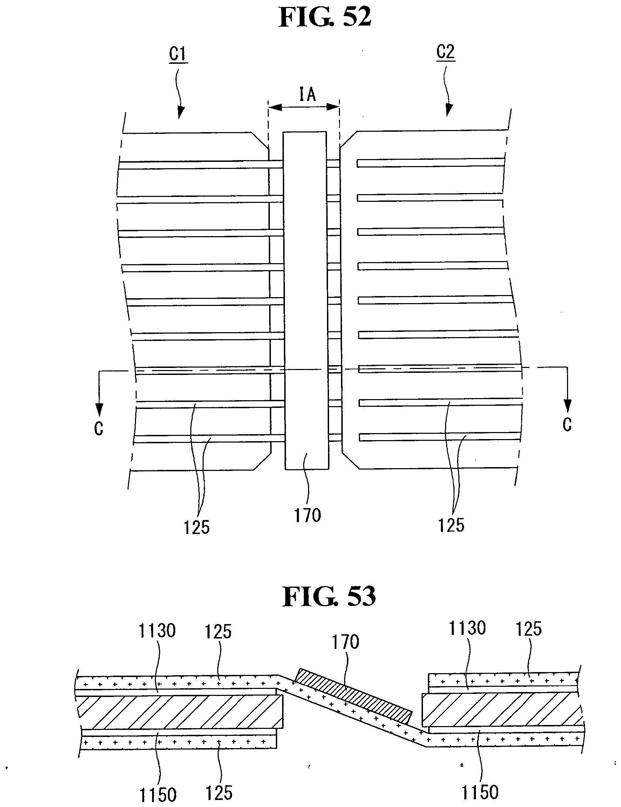

A reflector of the solar cell module shown in FIG. 42 is described in detail below with reference to FIGS. 52 to 58. FIG. 52 is a plane view of a reflector positioned in an interspace. FIG. 53 is a cross-sectional view taken along line C-C of FIG. 52.

The second solar cell C2 is separated from the first solar cell C1 by an interspace IA and is connected to the first solar cell C1 through the wiring member 125. A reflector 170 is positioned in the interspace IA.

The reflector 170 has a bar shape of a rectangular cuboid and is formed of a metal material with good reflectivity. For example, the reflector 170 may be formed of the same material as the electrodes 113 and 115 or the same material as the wiring member 125.

The reflector 170 is fixed to the wiring member 125 and is preferably soldered to the wiring member 125. In this instance, when the wiring member 125 is soldered to the electrodes 113 and 115, the wiring member 125 is soldered to the reflector 170 as well as the electrodes 113 and 115. Therefore, the number of manufacturing processes may decrease, and the manufacturing cost may be reduced.

Preferably, the reflector 170 is connected to all of the wiring members 125 connected to the first and second solar cells C1 and C2. In the example of the invention, the 12 wiring members 125 are used to electrically connect the first and second solar cells C1 and C2, and the reflector 170 is soldered to all of the 12 wiring members 125.

One side of the wiring member 125 is connected to the first electrode 1130 of the first solar cell C1, and the other side is connected to the second electrode 1150 of the second solar cell C2. Thus, the wiring member 125 is inclined at a predetermined angle in the interspace IA, and the reflector 170 connected to the wiring member 125 is inclined at a predetermined angle in the interspace IA.

Because of this, when light is incident in the interspace IA, the light is reflected from the surface of the reflector 170 and is incident on the second solar cell C2 adjacent to the first solar cell C1.

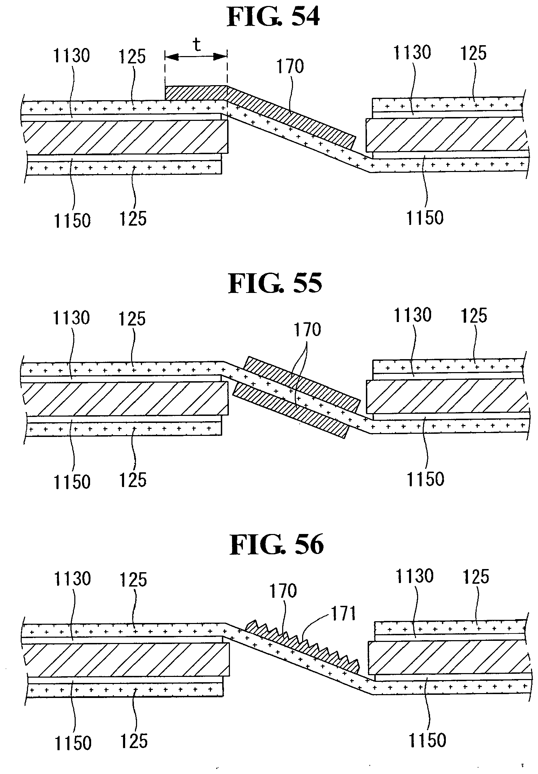

FIG. 54 shows that a portion of the reflector 170 is positioned on the first solar cell C1.

As shown in FIG. 54, the reflector 170 is positioned on the first solar cell C1 by a predetermined distance t from an end of the first solar cell C1 and is attached to the wiring member 125. Namely, the reflector 170 is not separated from the first solar cell C1 and is partially positioned on the first solar cell C1.

One side of the wiring member 125 is connected to the first electrode 1130 of the first solar cell C1, and the other side is connected to the second electrode 1150 of the second solar cell C2. Thus, the wiring member 125 bends downwardly at the end of the first solar cell C1. When the wiring member 125 formed of a metal layer bends downwardly at the end of the first solar cell C1, a disconnection is easily generated in a bending portion of the wiring member 125.

However, in the example of the invention, because the reflector 170 is positioned on the bending portion of the wiring member 125, the disconnection of the wiring member 125 may be prevented.

FIG. 55 shows that the reflector 170 is positioned on each of a front surface and a back surface of the wiring member 125 in the interspace IA.

The reflector 170 shown in FIG. 55 is the same as the above-described reflector 170, except that the reflector 170 is positioned on each of the front surface and the back surface of the wiring member 125. Because the reflector 170 is positioned on the back surface as well as the front surface of the wiring member 125, the disconnection of the wiring member 125 in the interspace IA may be prevented. Further, because the reflector 170 formed of the metal material is additionally formed in the interspace IA, a line resistance of the wiring member 125 may decrease.

FIG. 56 shows that uneven portions are formed on the surface of the reflector 170. As shown in FIG. 56, when light is reflected from the surface of the reflector 170, the light is diffusely reflected from the surface of the reflector 170 because the surface of the reflector 170 includes the uneven portions. Hence, an amount of light incident on the solar cell may efficiently increase.

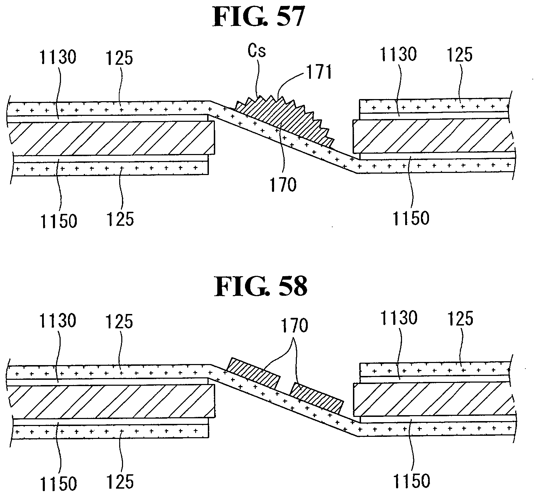

FIG. 57 shows that the surface of the reflector 170 forms an inclined surface Cs and uneven portions 71 are formed on the inclined surface Cs. FIG. 57 shows that the inclined surface Cs of the reflector 170 is round, as an example. However, as long as a height of the inclined surface Cs varies depending on a position, the inclined surface Cs may have any shape. When the surface of the reflector 170 has the inclined surface Cs as described above, light is further refracted from the surface of the reflector 170 toward the solar cell by an amount corresponding to an inclined angle. Therefore, an amount of light incident on the solar cell may efficiently increase.

So far, the example of the invention described that one reflector 170 is positioned in the interspace IA. However, at least two reflectors 170 may be positioned in the interspace IA as shown in FIG. 58. In this instance, the plurality of reflectors 170 may be disposed as described above with reference to FIGS. 53 to 57, or may be respectively configured to have different configurations. For example, when the two reflectors 170 are positioned in the interspace IA as shown in FIG. 58, one of the two reflectors 170 may have the configuration of FIG. 55, and the other may have the configuration of FIG. 57.

FIG. 58 shows that the reflector 170 is divided into the plurality of reflectors in the longitudinal direction of the wiring member 125, as an example. However, the reflector 170 may be divided into the plurality of reflectors in a direction crossing the wiring member 125.

## Claims

1. A solar cell module comprising a plurality of solar cells and a plurality of wiring members (125) connecting a first solar cell of the plurality of solar cells to a second solar cell adjacent to the first solar cell:
the plurality of solar cells, each including:
a semiconductor substrate (111),
first electrodes (1131) on a front surface of the semiconductor substrate (111) in parallel with one another and extended in a first direction,
a plurality of first pads (140, 141, 140a, 140e) each having a width greater than a width of the first electrode (1131), the plurality of first pads (140, 141, 140a, 140e) including a plurality of auxiliary pads (141, 140a) and a plurality of extension pads (140, 140e),
first connection electrodes (1133) extended in a second direction crossing the first direction and connected to the first electrodes on the front surface of the semiconductor substrate (111), and
second electrodes (1151) on a back surface of the semiconductor substrate,
**characterized in that**:
the plurality of first pads (140, 141, 140a, 140e) are selectively formed at crossings of the first electrodes (1131) and the first connection electrodes (1133),
the plurality of wiring members (125) connects the first electrodes (1131) of the first solar cell to the second electrodes (1151) of the second solar cell,
the wiring members (125) are extended in the second direction on the front surface of the first solar cell and overlapped with the first connection electrodes (1133),
a length in the second direction of the extension pad (140, 140e) is greater than a length in the second direction of the auxiliary pad (141, 140a),
a width (w1) in the first direction of the extension pad (140, 140e) is greater than a line width (Da) of the wiring members (125),
the extension pad (140, 140e) is positioned at the first electrode (1131) positioned at the outermost side among the first electrodes (1131) crossing the wiring member (125) along the second direction of the wiring member (125) on the front surface of the semiconductor substrate (15), and
each wiring member of the plurality of wiring members (125) is connected to the first connection electrode (1133) as well as to the plurality of auxiliary pads (141, 140a) and the plurality of extension pads (140, 140e).

2. The solar cell module of claim 1, wherein the second electrodes (1151) are positioned in parallel with one another in the plural, and
further comprising a plurality of second pads (140e', 140a') at crossings of the wiring members (125) and the second electrodes (1151).

3. The solar cell module of claim 2, wherein the second pads (140e', 140a') include an auxiliary pad (140a') and an extension pad (140e') each having a different size.

4. The solar cell module of claim 3, wherein in the second pads (140e', 140a'), a width or a length of the extension pad (140e') is greater than a width or a length of the auxiliary pad(140a'); and/or
wherein in each of the first and second pads (140, 141, 140a, 140e, 140a', 140e'), the extension pad (140, 140e, 140e') is positioned closer to an end portion of the semiconductor substrate (111) than to the auxiliary pad (141, 140a, 140a') along a longitudinal direction of the wiring member (125) in each of the plurality of solar cells.

5. The solar cell module of any one of claims 2 to 4, wherein in the second pads (140a', 140e'), the extension pad (140e') is positioned at outermost second electrodes (1151) among the second electrodes (1151) crossing the wiring members (125) along the longitudinal direction of the wiring member (125) in each of the plurality of solar cells.

6. The solar cell module of any one of claims 2 to 5, wherein at least one of a width, a length, or a number of the first pads (140, 141, 140a, 140e) is different from at least one of a width, a length, or a number of the second pads (140a', 140e'); and/or
wherein a number of the first pads (140, 141, 140a, 140e) is equal to or more than six and is equal to or less than a number of the first electrodes (1131), and
wherein a number of the second pads (140a', 140e') is equal to or more than six and is equal to or less than a number of the second electrodes (1151); and/or
wherein a number of the first pads (140, 141, 140a, 140e) is more than a number of the second pads (140a', 140e'); and/or
further comprising a plurality of second connection electrodes (1153) configured to electrically connect the second pads (140a', 140e') to the second electrodes (1151) in a longitudinal direction of the wiring member (125) in each of the plurality of solar cells.

7. The solar cell module of claim 6, wherein a width of the plurality of the first and second connection electrodes (1133, 1153) is equal to or greater than a width of the first electrodes and the second electrodes (1131, 1151) and is less than a width of the first pads and the second pads (140, 141, 140a, 140e, 140a', 140e').

8. The solar cell module of any one of claims 1 to 7, wherein a number of wiring members (125) is 6 to 30, and each wiring member (125) has a wire shape of a circular cross section having a diameter of 250 µm to 500 µm.

9. The solar cell module of claim 2 or of any one of claims 3 to 8 when dependent on claim 2, wherein in the first pads (140, 141, 140a, 140e) or the second pads (140a', 140e'), a width of the extension pad (140, 140e, 140e') is greater than a width of the wiring member (125) and is less than 2.5 mm; and/or
wherein a length of the first pads (140, 141, 140a, 140e) or the second pads (140a', 140e') is greater than a width of the first electrodes (1131) or the second electrodes (1151) and is less than 30 mm, and/or
wherein a ratio (m/n) of a number (m) of second pads (140a', 140e') to a number (n) of first pads (140, 141, 140a, 140e) satisfies 0.5 ≤ m/n < 1; and/or.
wherein a pitch (Pdb) between the second pads is greater than a pitch (Pdf) between the first pads.

10. The solar cell module of claim 1 to 9, wherein a pitch (Pf) between the first electrodes (1131) is equal to or greater than a pitch (Pd) between the second electrodes (1151); and/or
wherein a number of second electrodes (1151) is more than a number of first electrodes (1131).

11. The solar cell module of any one of claims 1 to 10, further comprising a reflector (170) positioned between the first solar cell and the second solar cell and connected to the wiring members (125).

## Patentansprüche

1. Solarzellenmodul, umfassend eine Vielzahl von Solarzellen und eine Vielzahl von Verdrahtungselementen (125), die eine erste Solarzelle von der Vielzahl von Solarzellen mit einer zweiten Solarzelle verbinden, die der ersten Solarzelle benachbart ist:
wobei jede von der Vielzahl von Solarzellen einschließt:
ein Halbleitersubstrat (111),
erste Elektroden (1131) auf einer vorderen Oberfläche des Halbleitersubstrats (111), die parallel zueinander sind und sich in einer ersten Richtung erstrecken,
eine Vielzahl von ersten Kontaktstellen (140, 141, 140a, 140e), die jeweils eine Breite aufweisen, die größer ist als eine Breite der ersten Elektrode (1131),
wobei die Vielzahl von ersten Kontaktstellen (140, 141, 140a, 140e) eine Vielzahl von Hilfskontaktstellen (141, 140a) und eine Vielzahl von Erweiterungskontaktstellen (140, 140e) einschließen,
erste Verbindungselektroden (1133), die sich in einer zweiten, die erste Richtung kreuzenden Richtung erstrecken und mit den ersten Elektroden auf der vorderen Oberfläche des Halbleitersubstrats (111) verbunden sind, und
zweite Elektroden (1151) auf einer hinteren Oberfläche des Halbleitersubstrats,
**dadurch gekennzeichnet, dass**:
die Vielzahl von ersten Kontaktstellen (140, 141, 140a, 140e) selektiv an Kreuzungsstellen der ersten Elektroden (1131) und der ersten Verbindungselektroden (1133) ausgebildet sind,
die Vielzahl von Verdrahtungselementen (125) die ersten Elektroden (1131) der ersten Solarzelle mit den zweiten Elektroden (1151) der zweiten Solarzelle verbindet,
die Verdrahtungselemente (125) sich in der zweiten Richtung auf der vorderen Oberfläche der ersten Solarzelle erstrecken und sich mit den ersten Verbindungselektroden (1133) überschneiden,
eine Länge der Erweiterungskontaktstelle (140, 140e) in der zweiten Richtung größer ist als eine Länge der Hilfskontaktstelle (141, 140a) in der zweiten Richtung,
eine Breite (w1) der Erweiterungskontaktstelle (140, 140e) in der ersten Richtung größer ist als eine Leitungsbreite (Da) der Verdrahtungselemente (125),
die Erweiterungskontaktstelle (140, 140e) an der ersten Elektrode (1131) positioniert ist, die von den ersten Elektroden (1131), die das Verdrahtungselement (125) kreuzen, auf der vorderen Oberfläche des Halbleitersubstrats (15) entlang der zweiten Richtung des Verdrahtungselements (125) auf der äußersten Seite positioniert ist, und
jedes Verdrahtungselement von der Vielzahl von Verdrahtungselementen (125) mit der ersten Verbindungselektrode (1133) sowie mit der Vielzahl von Hilfskontaktstellen (141, 140a) und der Vielzahl von Erweiterungskontaktstellen (140, 140e) verbunden ist.

2. Solarzellenmodul nach Anspruch 1, wobei die zweiten Elektroden (1151) parallel zueinander in der Mehrzahl positioniert sind, und
ferner eine Vielzahl von zweiten Kontaktstellen (140e', 140a') an Kreuzungsstellen der Verdrahtungselemente (125) und der zweiten Elektroden (1151) umfassend.

3. Solarzellenmodul nach Anspruch 2, wobei die zweiten Kontaktstellen (140e', 140a') eine Hilfskontaktstelle (140a') und eine Erweiterungskontaktstelle (140e') einschließen, die unterschiedlich groß sind.

4. Solarzellenmodul nach Anspruch 3, wobei bei den zweiten Kontaktstellen (140e', 140a') eine Breite oder eine Länge der Erweiterungskontaktstelle (140e') größer ist als eine Breite oder eine Länge der Hilfskontaktstelle (140a'); und/oder
wobei bei jeder von der Vielzahl von Solarzellen bei jeder von den ersten und zweiten Kontaktstellen (140, 141', 140a, 140e, 140a', 140e`) die Erweiterungskontaktstelle (140, 140e, 140e') entlang einer Längsrichtung des Verdrahtungselements (125) näher an einem Endabschnitt des Halbleitersubstrats (111) als an der Hilfskontaktstelle (141, 140a, 140a') positioniert ist.

5. Solarzellenmodul nach einem der Ansprüche 2 bis 4, wobei bei jeder von der Vielzahl von Solarzellen bei den zweiten Kontaktstellen (140a', 140e') die Erweiterungskontaktstelle (140e') an entlang der Längsrichtung des Verdrahtungselements (125) äußersten zweiten Elektroden (1151) von den zweiten Elektroden (1151), welche die Verdrahtungselemente (125) kreuzen, positioniert ist.

6. Solarzellenmodul nach einem der Ansprüche 2 bis 5, wobei sich mindestens eines von einer Breite, einer Länge oder einer Anzahl der ersten Kontaktstellen (140, 141, 140a, 140e) von mindestens einem von einer Breite, einer Länge oder einer Anzahl der zweiten Kontaktstellen (140a', 140e') unterscheidet; und/oder
wobei eine Anzahl der ersten Kontaktstellen (140, 141, 140a, 140e) gleich oder größer sechs ist und gleich oder kleiner ist als eine Anzahl der ersten Elektroden (1131), und
wobei eine Anzahl der zweiten Kontaktstellen (140e', 140a') gleich oder größer sechs ist und gleich oder kleiner ist als eine Anzahl der zweiten Elektroden (1151); und/oder
wobei eine Anzahl der ersten Kontaktstellen (140, 141, 140a, 140e) größer ist als eine Anzahl der zweiten Kontaktstellen (140a', 140e'); und/oder
ferner in jeder von der Vielzahl von Solarzellen eine Vielzahl von zweiten Verbindungselektroden (1153) umfassend, die konfiguriert sind, um die zweiten Kontaktstellen (140a', 140e') in einer Längsrichtung des Verdrahtungselements (125) mit den zweiten Elektroden (1151) elektrisch zu verbinden.

7. Solarzellenmodul nach Anspruch 6, wobei eine Breite der Vielzahl von den ersten und zweiten Verbindungselektroden (1133, 1153) gleich oder größer ist als eine Breite der ersten Elektroden und der zweiten Elektroden (1131, 1151) und kleiner ist als eine Breite der ersten Kontaktstellen und der zweiten Kontaktstellen (140, 141, 140a, 140e, 140a', 140e').

8. Solarzellenmodul nach einem der Ansprüche 1 bis 7, wobei eine Anzahl von Verdrahtungselementen (125) 6 bis 30 beträgt und jedes Verdrahtungselement (125) eine Drahtform mit einem kreisförmigen Querschnitt aufweist, der einen Durchmesser von 250 µm bis 500 µm hat.

9. Solarzellenmodul nach Anspruch 2 oder einem der Ansprüche 3 bis 8, wenn abhängig von Anspruch 2, wobei bei den ersten Kontaktstellen (140, 141, 140a, 140e) oder den zweiten Kontaktstellen (140a', 140e') eine Breite der Erweiterungskontaktstelle (140, 140e, 140e') größer ist als eine Breite des Verdrahtungselements (125) und kleiner ist als 2,5 mm; und/oder
wobei eine Länge der ersten Kontaktstellen (140, 141, 140a, 140e) oder der zweiten Kontaktstellen (140a', 140e') größer ist als eine Breite der ersten Elektroden (1131) oder der zweiten Elektroden (1151) und kleiner ist als 30 mm, und/oder
wobei ein Verhältnis (m/n) einer Anzahl (m) von zweiten Kontaktstellen (140a', 140e') zu einer Anzahl (n) von ersten Kontaktstellen (140, 141, 140a, 140e) 0,5 ≤ m/n < 1 erfüllt; und/oder.
wobei ein Abstand (Pdb) zwischen den zweiten Kontaktstellen größer ist als ein Abstand (Pdf) zwischen den ersten Kontaktstellen.

10. Solarzellenmodul nach Anspruch 1 bis 9, wobei ein Abstand (Pf) zwischen den ersten Elektroden (1131) gleich oder größer ist als ein Abstand (Pd) zwischen den zweiten Elektroden (1151); und/oder
wobei eine Anzahl von zweiten Elektroden (1151) größer ist als eine Anzahl von ersten Elektroden (1131).

11. Solarzellenmodul nach einem der Ansprüche 1 bis 10, ferner einen Reflektor (170) umfassend, der zwischen der ersten Solarzelle und der zweiten Solarzelle positioniert und mit den Verdrahtungselementen (125) verbunden ist.

## Revendications

1. Module de cellules solaires comprenant une pluralité de cellules solaires et une pluralité d'éléments de câblage (125) reliant une première cellule solaire de la pluralité de cellules solaires à une seconde cellule solaire adjacente à la première cellule solaire:
la pluralité de cellules solaires, comprenant chacune:
un substrat semi-conducteur (111),
des premières électrodes (1131) sur une surface avant du substrat semi-conducteur (111), parallèles les unes aux autres et étendues dans une première direction,
une pluralité de premiers tampons (140, 141, 140a, 140e) ayant chacun une largeur supérieure à une largeur de la première électrode (1131), la pluralité de premiers tampons (140, 141, 140a, 140e) comprenant une pluralité de tampons auxiliaires (141, 140a) et une pluralité de tampons d'extension (140, 140e),
des premières électrodes de connexion (1133) étendues dans une seconde direction croisant la première direction et connectées aux premières électrodes sur la surface avant du substrat semi-conducteur (111), et des secondes électrodes (1151) sur une surface arrière du substrat semi-conducteur,
**caractérisées par le fait que**:
la pluralité de premiers tampons (140, 141, 140a, 140e) sont sélectivement formés aux croisements des premières électrodes (1131) et des premières électrodes de connexion (1133),
la pluralité d'éléments de câblage (125) relie les premières électrodes (1131) de la première cellule solaire aux secondes électrodes (1151) de la seconde cellule solaire,
les éléments de câblage (125) sont étendus dans la seconde direction sur la surface avant de la première cellule solaire et se superposent aux premières électrodes de connexion (1133),
une longueur dans la seconde direction du tampon d'extension (140, 140e) est supérieure à une longueur dans la seconde direction du tampon auxiliaire (141, 140a),
une largeur (w1) dans la première direction du tampon d'extension (140,140e) est supérieure à une largeur de ligne (Da) des éléments de câblage (125),
le tampon d'extension (140, 140e) est positionné au niveau de la première électrode (1131) placée du côté le plus extérieur parmi les premières électrodes (1131) traversant l'élément de câblage (125) le long de la seconde direction de l'élément de câblage (125) sur la surface avant du substrat semi-conducteur (15), et
chaque élément de câblage de la pluralité d'éléments de câblage (125) est connecté à la première électrode de connexion (1133) ainsi qu'à la pluralité de tampons auxiliaires (141, 140a) et à la pluralité de tampons d'extension (140, 140e).

2. Module de cellules solaires selon la revendication 1, dans lequel les secondes électrodes (1151) sont positionnées parallèlement l'une à l'autre dans la pluralité, et
comprenant en outre une pluralité de seconds tampons (140e', 140a') aux croisements des éléments de câblage (125) et des secondes électrodes (1151).

3. Module de cellules solaires selon la revendication 2, dans lequel les seconds tampons (140e', 140a') comprennent un tampon auxiliaire (140a') et un tampon d'extension (140e') ayant chacun une taille différente.

4. Module de cellules solaires selon la revendication 3, dans lequel dans les seconds tampons (140e', 140a'), une largeur ou une longueur du tampon d'extension (140e') est supérieure à une largeur ou une longueur du tampon auxiliaire (140a'); et/ou
dans lequel, dans chacun des premier et second tampons (140, 141, 140a, 140e, 140a', 140e'), le tampon d'extension (140, 140e, 140e') est positionné plus près d'une partie terminale du substrat semi-conducteur (111) que le tampon auxiliaire (141, 140a, 140a') le long d'une direction longitudinale de l'élément de câblage (125) dans chacune de la pluralité de cellules solaires.

5. Module de cellules solaires selon l'une quelconque des revendications 2 à 4, dans lequel dans les seconds tampons (140a', 140e'), le tampon d'extension (140e') est positionné au niveau des secondes électrodes (1151) les plus extérieures parmi les secondes électrodes (1151) traversant les éléments de câblage (125) le long de la direction longitudinale de l'élément de câblage (125) dans chacune de la pluralité de cellules solaires.

6. Module de cellules solaires selon l'une quelconque des revendications 2 à 5, dans lequel au moins une d'une largeur, d'une longueur ou d'un nombre des premiers tampons (140, 141, 140a, 140e) est différent(e) d'au moins une d'une largeur, d'une longueur ou d'un nombre des seconds tampons (140a',140e'); et/ou
dans lequel un nombre des premiers tampons (140, 141, 140a, 140e) est égal ou supérieur à six et est égal ou inférieur à un nombre des premières électrodes (1131), et
dans lequel un nombre de seconds tampons (140a', 140e') est égal ou supérieur à six et est égal ou inférieur à un nombre des secondes électrodes (1151); et/ou dans lequel le nombre de premiers tampons (140, 141, 140a, 140e) est supérieur au nombre de seconds tampons (140a', 140e'); et/ou
comprenant en outre une pluralité de secondes électrodes de connexion (1153) configurées pour connecter électriquement les seconds tampons (140a', 140e') aux secondes électrodes (1151) dans une direction longitudinale de l'élément de câblage (125) dans chacune de la pluralité de cellules solaires.

7. Module de cellules solaires selon la revendication 6, dans lequel une largeur de la pluralité de la première et de la seconde électrodes de connexion (1133, 1153) est égale ou supérieure à une largeur de la première électrode et de la seconde électrode (1131, 1151) et est inférieure à une largeur des premiers tampons et des seconds tampons (140, 141, 140a, 140e, 140a', 140e').

8. Module de cellules solaires selon l'une des revendications 1 à 7, dans lequel le nombre d'éléments de câblage (125) est compris entre 6 et 30, et chaque élément de câblage (125) a la forme d'un fil de section circulaire d'un diamètre de 250 µm à 500 µm.

9. Module de cellules solaires selon la revendication 2 ou selon l'une quelconque des revendications 3 à 8 lorsqu'elles dépendent de la revendication 2, dans lequel, dans les premiers tampons (140, 141, 140a, 140e) ou les seconds tampons (140a', 140e'), une largeur du tampon d'extension (140, 140e, 140e') est supérieure à une largeur de l'élément de câblage (125) et est inférieure à 2,5 mm; et/ou
dans lequel la longueur des premiers tampons (140, 141, 140a, 140e) ou des seconds tampons (140a', 140e') est supérieure à la largeur des premières électrodes (1131) ou des secondes électrodes (1151) et est inférieure à 30 mm, et/ou
dans lequel le rapport (m/n) entre un nombre (m) de seconds tampons (140a', 140e') et un nombre (n) de premiers tampons (140, 141, 140a, 140e) est égal à 0,5 < m/n < 1; et/ou.
dans lequel un pas (Pdb) entre les seconds tampons est supérieur à un pas (Pdf) entre les premiers tampons.

10. Module de cellules solaires selon les revendications 1 à 9, dans lequel un pas (Pf) entre les premières électrodes (1131) est égal ou supérieur à un pas (Pd) entre les secondes électrodes (1151); et/ou
dans lequel un nombre de secondes électrodes (1151) est supérieur au nombre de premières électrodes (1131).

11. Module de cellules solaires selon l'une quelconque des revendications 1 à 10 comprenant, en outre, un réflecteur (170) placé entre la première cellule solaire et la seconde cellule solaire et connecté aux éléments de câblage (125).
